(19) Europäisches Patentamt / European Patent Office / Office européen des brevets

(11) **EP 3 794 287 B1**

(12) **EUROPEAN PATENT SPECIFICATION**

(45) Date of publication and mention
of the grant of the patent:
**20.09.2023   Bulletin 2023/38**

(21) Application number: **19723456.0**

(22) Date of filing: **16.05.2019**

(51) International Patent Classification (IPC):
**F24D 17/00** $^{(2022.01)}$

(52) Cooperative Patent Classification (CPC):
**F24D 17/0073; C02F 1/008; C02F 1/02;** C02F 1/32;
C02F 2209/02; C02F 2209/36; C02F 2209/40;
C02F 2303/04

(86) International application number:
**PCT/EP2019/062716**

(87) International publication number:
**WO 2019/219864 (21.11.2019 Gazette 2019/47)**

(54) **THERMOHYDRAULIC AND BIOLOGIC MODEL-BASED CONTROL**

AUF THERMOHYDRAULISCHEM UND BIOLOGISCHEM MODELL BASIERENDE STEUERUNG

COMMANDE BASÉE SUR UN MODÈLE THERMOHYDRAULIQUE ET BIOLOGIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.05.2018   EP 18173379**

(43) Date of publication of application:
**24.03.2021   Bulletin 2021/12**

(73) Proprietor: **Universiteit Gent**
**9000 Gent (BE)**

(72) Inventors:
• **VAN KENHOVE, Elisa**
**9000 Gent (BE)**
• **LAVERGE, Jelle**
**8500 Kortrijk (BE)**

(74) Representative: **Winger**
**Mouterij 16 bus 101**
**3190 Boortmeerbeek (BE)**

(56) References cited:
EP-A1- 1 626 034          WO-A1-01/63182
WO-A1-2012/161804      WO-A2-2013/014411
US-A1- 2010 195 991     US-A1- 2011 272 117

• **ELISA VAN KENHOVE ET AL: "Coupled
thermodynamic and biologic modeling of
Legionella Pneumophila proliferation in
domestic hot water systems", HEALTHY
BUILDINGS CONFERENCE; D: ENERGY &
SUSTAINABILITY; D.2. ENERGY AND HEALTH,
20 May 2015 (2015-05-20), pages 1-8,
XP055525199, NL cited in the application**
• **VAN KENHOVE E ET AL: "Coupled
thermodynamic and biologic modeling of
legionella pneumophila proliferation in domestic
hot water systems", COMPENDEX,
ENGINEERING INFORMATION, INC., NEW YORK,
NY, US, 1 January 2015 (2015-01-01),
XP002786621,**

- **DATABASE COMPENDEX [Online]
  ENGINEERING INFORMATION, INC., NEW YORK,
  NY, US; 2015, VAN KENHOVE E ET AL: "Coupled
  thermodynamic and biologic modeling of
  legionella pneumophila proliferation in domestic
  hot water systems", Database accession no.
  E20183605780418 & VAN KENHOVE E ET AL:
  "Coupled thermodynamic and biologic modeling
  of legionella pneumophila proliferation in
  domestic hot water systems", HEALTHY
  BUILDINGS EUROPE 2015, HB 2015 -
  CONFERENCE PROCEEDINGS - HEALTHY
  BUILDINGS EUROPE 2015, HB 2015 -
  CONFERENCE PROCEEDINGS 2015
  INTERNATIONAL SOCIETY OF INDOOR AIR
  QUALITY AND CLIMATE USA, vol. 2015-May,
  2015,**

**Description**

**Field of the invention**

The invention relates to the field of bacterial control. More specifically it relates to methods and devices for providing bacterial activity suppression in fluid distribution systems, such as hot water distribution systems, environmental control systems controlled by heat, ventilation and/or air conditioning and air circulation systems.

**Background of the invention**

Bacterial proliferation is one of the underlying risks in infrastructures such as hot water supplies, reservoirs, air conditioning and ventilation systems, cooling towers, etc. These infrastructures handle water, aerosols, gases or vapors in conditions which in many cases contribute to proliferation of bacterial colonies.

Therefore, it is necessary to provide effective ways of controlling bacterial activity. In case of domestic hot water (DHW) systems, thermal treatments are used for bacterial pasteurization, which increases energy demand. One of the main reasons for the high energy demand is that the water for domestic use is produced, stored and distributed at temperatures above 60°C. This mitigates the risk of infecting the DHW system with bacteria such as *Legionella pneumophila.* This is a bacteria which causes, upon exposure, i.e. breathing in the aerosols, acute respiratory disease or severe pneumonia. At these temperatures, *L. pneumophila* growth is stopped and remaining bacteria are effectively killed. However, for most of the domestic hot water applications, like taking a shower or washing hands, temperatures of only 30-40°C are required. This disparity (between 60°C and 40°C) doubles the temperature difference between DHW system and environment which has a negative effect on the heat dissipation of the systems and on the efficiency of DHW production units, such as heat pumps.

In "Coupled thermodynamic and biologic modeling of Legionella Pneumophila proliferation in domestic hot water systems" by Elisa Van Kenhove et al., Healthy Buildings Conference, Eindhoven, 2015 a system is described for simulating the growth of Legionella in the design phase of a domestic hot water system and to test the effectiveness of disinfection techniques on an infected system, so as to optimize the design of domestic hot water systems. In WO2013/014411 a controller is described for a boiler of a liquid heating system. The controller may be arranged to take into account the growth of bacteria in the boiler, based on a number of temperature measurements in the boiler.

Nevertheless, there is still room for improving the energy efficiency of the system in use, so as to allow to reduce the consumption of energy, while still providing sufficient safety with respect to the risk of infecting the system.

It would be desirable to have more energy-efficient implementations for buildings, which reduces energy requirements. While it is possible to perform this energy reduction by trial and error, this method is not safe. It would also be desirable to reduce contamination of bacteria in buildings and also in industrial applications in general, not only in water distribution systems, but also in any other building or industrial infrastructure prone to bacterial contamination, especially on those systems making use of water or vapor.

**Summary of the invention**

It is an object of embodiments of the present invention to provide a control unit for controlling heating (thermal treatment) and/or other kinds of de-bacterisation of a fluid system, and a method of providing such heating and/or thermal treatment, thus providing efficient and safe controlling of bacterial activity in an energetically effective way in a fluid distribution system, as well as methods to install or adapt distribution systems for obtaining energetically effective bacterial suppression or removal, as well as safe fluid systems with lower energy demand and safe bacterial contamination.

Embodiments of the present invention therefore relate to a control system for hot water and heating and ventilation systems including condensation with effective bacterial control and energy consumption. It can be applied to circulative systems or distribution systems from one point to an outlet point, such as water distribution systems, environmental control systems based on heating, ventilation or air conditioning and air circulation or distribution systems (DHW, HVAC, heating, etc.), cooling towers, etc..

It is an advantage of embodiments of the present invention that a heater can set a temperature and heating regime which gives at least the minimum temperature required for user comfort while at the same time working under low energy consumption conditions, especially at fluid interchange portions of fluid distribution systems (such as drain trays of HVAC systems or taps of DHW systems). The user comfort temperature may for example be between 37°C and 45°C. The present invention relates to a control unit adapted to regulate at least one de-bacterisation unit of a fluid system according to claim 1.

The control unit may generate a signal when the bacterial concentration is close to the predetermined value or reaches the predetermined value. Such signal may for instance comprise a sound or light alarm, a text message on your mobile phone,...

Where in embodiments of the present invention reference is made to a plurality of locations throughout the fluid system, it is meant a plurality of locations along the fluid path between production unit and fluid outlet, for instance locations of at least two different fluid system parts of the fluid systems, the fluid system parts at least comprising the production unit, the one or more pipe and the one or more fluid outlets. Where in embodiments of the present invention reference is made to dynamic modelling, reference is made to modelling as function of time. It is an advantage of embodiments of the present invention that bacterial control and decontamination can be performed while reducing energy consumption and waste and/or reducing water waste by tailoring the heating of the fluid, as well as the scheme and sequence of the heating, taking into account models of bacterial growth in the fluid system. It is a further advantage that zones wherein the speed of the fluid is reduced, or stagnant, can be taken into account in the model of bacterial growth, allowing dynamic adaptation of decontamination strategies.

The input of the module may further receive a first flow rate of the fluid as a function of time, the first flow rate being sensed by the at least one sensing unit of the fluid system, and said module being adapted for obtaining second flow rates at the plurality of locations throughout the fluid system as a function of time, said obtaining taking into account said first flow rate. Preferably, the sensing unit of the fluid system senses at least a first temperature and a first flow rate of the fluid at the same or a different location throughout the fluid system. The sensing unit may comprise a first temperature sensor for sensing the first temperature and a second sensor for sensing or deriving a first flow rate of the fluid in the fluid system. The location of the first temperature sensor and the second flow rate sensor sensor may be the same or differ from each other. The de-bacterisation unit may be any of a heater for heating the fluid for reducing the bacterial concentration, a chemical unit for inducing a chemical process for reducing the bacterial concentration, an electrochemical unit for reducing the bacterial concentration or a unit for reducing the bacterial concentration based on UV illumination or filtration. The de-bacterisation unit may be an electrochemical unit for reducing the bacterial concentration by anodic oxidation or by copper and/or silver ionization.

The de-bacterisation unit may comprise a heater of the production unit for producing a heated fluid, the heater thus, on the one hand, being arranged for, when required, heating the fluid to a comfort temperature at the at least one fluid output when required and on the other hand being arranged for inducing a heat shock for reducing the bacterial concentration in the fluid system when the predicted bacterial concentration reaches the predetermined value.

The module may further be programmed for modelling bacterial growth in a biofilm in the fluid system. The module may further be programmed for modelling interaction between bacterial growth in the fluid and bacterial growth in the biofilm.

It is an advantage of embodiments of the present invention that the controller allows to obtain/determine the temperature, and optionally the flow rate, throughout the whole fluid system, i.e. at every location throughout the fluid system, at every moment in time. It is an advantage of embodiments of the present invention that the controller takes into account the whole fluid system when determining bacterial growth in the fluid, and optionally in the biofilm, i.e. that bacterial growth in the fluid, and optionally in the biofilm, can be determined throughout the whole fluid system, i.e. at every location throughout the fluid system.

The module may be programmed for thermohydraulic modelling the fluid system for determining based thereon the temperature at a plurality of locations in the fluid system as function of time. Alternatively or in addition thereto, the module may be adapted for obtaining temperature information from a plurality of temperature sensors for sensing the temperature in the fluid system.

The module may include an input for receiving at least a temperature from at least one sensing unit in the fluid system. The module may include an input for receiving at least a flow rate from at least one sensing unit in the fluid system. It is an advantage of embodiments of the present invention that a parameter and changes thereof can be measured and taken into account in the models. Advantageously the temperature is measured, e.g. in combination with the flow rate in the system.

The module may include an output for sending control signals to the de-bacterisation unit. It is an advantage of embodiments of the present invention that controlling the temperature of the fluid can be performed in real time, for example taking into account changes in temperature and/or flow rate of the fluid.

The module may further include a model of any of biofilm growth, turbulence, fluid speed, fluid pressure, thermal isolation of the fluid system. It is an advantage of embodiments of the present invention that other parameters, aside of bacterial growth in the fluid system, e.g. the fluid distribution system therein, can be taken into account, for example dynamic parameters such as turbulence or biofilm growth, as well as passive parameters such as thermal isolation of the distribution system.

The models for bacterial growth may comprise models for growth of legionella. It is an advantage of embodiments of the present invention that legionella, e.g. a bacteria from the genus legionella, can be controlled below a predetermined level in the system, e.g. in the fluid (e.g. water) in the fluid system.

The de-bacterisation unit may be a separate heater or may be the heater of the production unit. The control unit may be adapted to dynamically regulate this heater for controlling the temperature of the fluid at 55°C or more for obtaining a 4-log reduction in 50 minutes or less. It is an advantage of embodiments of the present invention that bacterial populations in water can be specifically target, thus saving heating energy.

One or both of the models of legionella growth may include information regarding the variation of concentration over time as function of temperature at a temperature at least between 20°C and 45°C for legionella growth in fluid and optionally also in biofilm. It is an advantage of embodiments of the present invention that the temperature range of growth of active legionella can be taken into account for control of the temperature, for suppressing legionella activity. The information may be or include growth curves, e.g. the growth curve of bacteria in fluid and the growth curve of bacteria in biofilm. Alternatively or in addition thereto the information may also comprise parameters that influence the growth of bacteria, such as for example one or more of temperature, flow, thickness of the biofilm, materials of the pipes used, roughness of the pipes used, nSeg being a simulation parameter that determines what the number of nodes is that is calculated per pipe, the initial amount of bacteria that is present, the mass transfer coefficient, ....

The module may further comprise predictive algorithms for predicting fluid consumption, based on fluid consumption behavior of the user, thereby allowing the control unit to anticipate fluid consumption and adjust regulation of the de-bacterisation unit.

Modelling bacterial growth in the fluid and bacterial growth in the biofilm may comprise modelling bacterial growth in the fluid and in the biofilm of any of an air conditioning system, ventilation system, cooling system, or heating system, or a hot water distribution system.

In ventilation systems, the fluid may be air. It is an advantage of embodiments of the present invention that HVAC systems can be safely maintained free from active bacteria, e.g. Legionella, by including models of bacterial growth adapted to these systems, for example including the bacterial growth on a heat exchanger included in these systems. The control unit may have a fluid distribution system, including at least one fluid-interchange portion, comprises a cooling tower.

It is an advantage of embodiments of the present invention that cooling towers, which are sources of bacterial diseases, can also be modelled. It is an advantage of embodiments of the present invention that bacteria concentration in hot water for usage and consumption can be controlled to be below a predetermined threshold.

The control unit may have a fluid distribution system including at least one fluid-interchange portion comprising a tap, a fluid-interchange portion being a portion of the fluid system where the fluid may become in contact with the environment, in particular with the user of the fluid system. It is an advantage of embodiments of the present invention that water outlets for human usage and consumption can be taken into account in the model.

In one aspect, the present invention also relates to a fluid circulation or distribution system including a control unit as described above, a heater, and any of a heat exchanger, and/or a fluid circulation system, and/or a condenser, and/or a cooling tower and/or a hot water storage tank, at least one pipe and at least one water outlet.

It is an advantage of embodiments of the present invention that an air conditioning system, or cooling or heating systems, or hot water distribution system which may include evaporators and cooling towers, can be provided with reduced or suppressed bacterial activity. The heater may be any type of heater, such as for example a heat pump, a solar collector, a gas condensation system, etc.

The present invention also relates to a method of regulating at least one de-bacterisation unit of a fluid system according to claim 10.

It is an advantage of embodiments of the present invention that heating of fluid can be provided, by reducing demand of energy, while keeping bacterial concentration below a predetermined threshold.

Modeling bacterial growth may comprise predictive simulating taking into account fluid consumption behavior of the user, thereby allowing the control unit to anticipate fluid consumption and adjust regulation of the de-bacterisation unit.

The method may include the step of installing the control unit as described in a fluid system. It is an advantage of embodiments of the present invention that an existing HVAC system or water supply system can be adapted by including a programmable control unit according to embodiments of the present invention.

The method may further include calibrating the module of the control unit based on parameters of the fluid distribution system. It is an advantage of embodiments of the present invention that a control unit can be adapted and programmed for calculating bacterial growth in a fluid distribution system.

The present invention also relates to a computer program product for performing, when executed on a processor, a method as described above. The computer program product may be a computer tool.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

**Brief description of the drawings**

FIG. 1 illustrates an exemplary embodiment of a control unit and a fluid distribution system including a heater according to embodiments of the present invention.

FIG 2 illustrates an alternative embodiment of a control unit and a fluid distribution system including a heater according to embodiments of the present invention, including sensors.

FIG 3 illustrates an alternative embodiment of a control unit and a fluid distribution system including a heater according to embodiments of the present invention, including a heater and a separate tank.

FIG 4 illustrates a method according to embodiments of the present invention.

FIG 5 illustrates the estimation of the mean generation time (time to double the number of cells) of *Legionella pneumophila* in tap water.

FIG 6 illustrates the change in decimal reduction time (90% reduction in Legionella pneumophila) with temperature.

FIG 7 illustrates the multiplication rate and death rate of Legionella pneumophila in water and biofilm with temperature.

FIG 8 illustrates the customized Pipe model in icon view (Modelica) with addition of *Legionella pneumophila* growth equations, illustrating an example of a model in a component of a system.

FIG 9 illustrates a Pipe model with addition of *Legionella pneumophila* growth equations (Modelica diagram view), illustrating an example of a model in a component of a system.

FIG 10 illustrates customized StratifiedEnhancedInternalHex boiler model in icon view (Modelica) with addition of *L. pneumophila* growth equations.

FIG 11 illustrates a boiler model with addition of *L. pneumophila* growth equations (Modelica diagram view).

FIG 12 illustrates a domestic hot water system with customized boiler and piping.

FIG 13 shows a simulation of the mean generation time (time to double the number of cells) of *Legionella pneumophila* in water, as a function of water temperature.

FIG 14 shows a simulation of the decimal reduction time (90% reduction in *Legionella pneumophila* in water) as a function of water temperature.

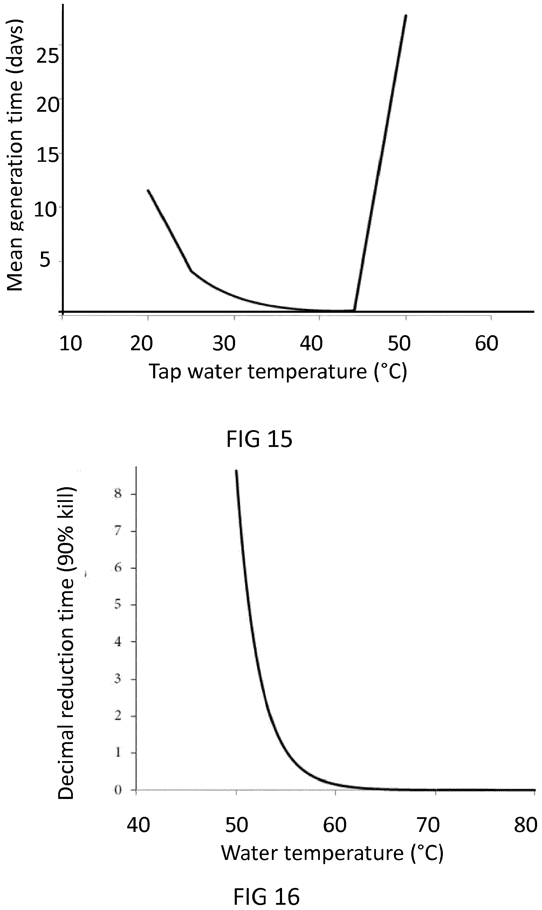

FIG 15 shows a simulation of mean generation time (time to double the number of cells) of *Legionella pneumophila* in biofilm as a function of temperature.

FIG 16 shows a simulation of the change in decimal reduction time (90% reduction in *Legionella pneumophila*) in biofilm as a function of temperature.

FIG 17 shows a simulation of overall growth function of *Legionella pneumophila* in a water distribution system.

FIG 18 illustrates a method of control through a virtual twin system.

FIG 19 shows the predicted bacterial concentration and the influence thereon of thermal shock disinfection and tap cycles as a function of time.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

**Detailed description of illustrative embodiments**

The present invention will be described with respect to particular embodiments and with reference to certain drawings but the invention is not limited thereto but only by the claims. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Fluid systems, especially those using heated water, are prone to develop bacterial contamination, and become sources of diseases which may spread via water interchanged with the exterior of the system, e.g. via taps or via water particles in air suspension. Usually these systems include one or more points of use or one or more portions where the fluid is or may become in contact with the exterior upon use , for example, a chiller of a heating, ventilation and air conditioning (HVAC) system, or a tap of a domestic hot water (DHW) system, such portion of the fluid system hereinafter called a fluid outlet or a fluid-interchange portion. These portions are a focus of infection if the fluid in the system becomes contaminated.

The present invention relates to methods and devices to control bacterial activity, for example thermal control, in such fluid distribution systems. Where in embodiments of the present invention reference is made to bacterial activity, reference is made to the reproductive state of a population of bacteria. Bacterial activity is high when reproducing, and it is low, or suppressed, when bacteria is dormant or killed. It is usually preferable to obtain low bacterial activity by decontamination of the fluid, e.g. by killing bacteria, for example by pasteurization.

Bacterial activity in the fluid of a fluid distribution system can be modelled taking into account the design of the system, as well as its geometric and physical parameters such as heat conductivity of the fluid transport ducts, duct dimensions, branching, stagnation areas, fluid temperature, etc. Based on said model, it is possible to set thermal regulation on a heater, thereby for example heating the fluid up at predetermined moments in time, for killing bacteria and maintaining its activity under a non-harmful threshold. However, thermal regulation based solely on heating at high temperature is sub-optimal, in view of the high energy consumption. The heating should be increased, which usually results in a waste of energy.

The simulation model can be further developed, obtaining effective thermal disinfection measures while keeping an equilibrium between energy efficiency and decontamination. The model includes equations relating to the bacterial growth in a fluid (e.g. water), but also to bacterial growth in biofilm present in the fluid system.

A biofilm includes a consortium of microbial cells attached to the surface of at least some portions of the fluid distribution system. Wherever there is water, biofilm growth can occur, for example in storage tanks, pipes, expansion vessels, humidifiers and cooling towers. Biofilms can grow very easily in domestic hot water pipes since they provide a moist and warm environment for the biofilm to thrive. The biofilms are associated together, forming a hydrated extracellular anionic polymer matrix and comprises mainly exopolysaccharides, biological macromolecules (proteins, lipids, DNA, RNA), cellular lysis products, nutrients, metabolites, and inorganic compounds and particles, etc. Micro colonies of bacterial cells may be encased in the matrix and separated from each other by interstitial water channels, allowing transport of nutrients, oxygen, etc. Biofilm communities are dynamic and provide survival and growth of the associated microorganisms. Bacteria, such as *Legionella pneumophila* bacteria, can attach to the biofilm or to other organisms living therein, maturate and then disperse in the fluid.

Bacterial activity in the fluid is very different from the activity in the biofilm since the bacteria, e.g. Legionella, grow in amoebes in the biofilm so than can resist higher temperatures. Therefore a simulation taking into account both environments reflects closely the actual behavior of bacteria, their activity and spread in a fluid distribution system. These improved models take into account the system itself, so an accurate model of the distribution of the biofilm therein can be used, for example including its geometry, geometry of fluid ducts, presence and size of water reservoirs, etc. The present invention allows selecting a thermal treatment which suits the particular fluid distribution system, ensuring that the thermal treatment is effective even in variable conditions, with low waste of energy.

These models may include mathematical relationships representing bacteria transport between biofilm and fluid (from fluid to biofilm and vice versa), as well as biofilm growth, and other parameters such as roughness of the biofilm, oxygen and access to nutrients, etc. Further relationships may include flow conditions, turbulence, pH of the fluid, thermal conductivity and losses of the distribution system (e.g. of the pipes), etc.

Further, one or more measurements of relevant parameters may be performed on the fluid and/or the system, which can be taken into account in the model, for example measurements of temperature, volume of fluid per unit of area per unit of time, pressure, size of the tubes used, flow levels, etc., by using e.g. temperature sensors, flow sensors, etc.

The present invention can be applied, for example, in domestic hot water (DHW) systems, or in heating/cooling or air ventilation systems, thus obtaining more energy-efficient and healthy buildings. The present invention may be applied also to medical facilities and hospitals, and to industrial environments, such as cooling towers.

In a first aspect, a control unit adapted to regulate at least one de-bacterisation unit of a fluid system is described. A typical fluid system comprises the de-bacterisation unit, a production unit for producing a heated fluid heated to a predetermined temperature, at least one pipe for transporting the fluid between the production unit and at least one fluid outlet, the at least one fluid outlet and at least one sensor for sensing a first temperature and/or a first flow rate of the fluid at a first location in the fluid system as a function of time. The de-bacterisation unit may be based on one or more principles, e.g. thermal de-bacterisation, electrochemical de-bacterisation, physical de-bacterisation or chemical de-bacterisation. In some embodiments of the present invention, the de-bacterisation unit, in case it is based for thermal de-bacterisation, may be the same as the heater of the production unit for producing a heated fluid, or may be different. It is to be noted that de-bacterisation relates to reduction of bacteria, e.g. below a certain threshold, and does not necessarily imply that all bacteria are removed. The at least one sensor may be provided in the production unit of the fluid system. Preferably, the at least one sensor is provided in a part of the at least one pipe for transporting the fluid from the production unit to the at least one fluid outlet, preferably at a location in the at least one pipe close to the production unit. In circulative systems, the at least one sensor may be provided in a part of the at least one pipe, for instance the re-circulation pipe for transporting the fluid from the at least one fluid outlet to the production unit. The control unit includes a module adapted for obtaining a temperature and/or flow rate at a plurality of locations throughout the fluid system as function of time and programmed for modelling bacterial growth in the fluid in the fluid system as function of time based on the obtained first temperature and/or the first flow rate of the fluid in the system. The module also is programmed for predicting, based on the modelling, the bacterial concentration at the at least one fluid outlet over time. The control unit is further being adapted for driving the de-bacterisation unit. The control unit is also being adapted for determining, based on said predicted bacterial concentration over time obtained by the module, moments in time when the bacterial concentration reaches a predetermined value in the fluid system, preferably at the at least one fluid outlet in the fluid system, and for, in reply thereto, driving at these moments in time the de-bacterisation unit so as to reduce bacterial concentration in the fluid system, preferably at the at least one fluid outlet in the fluid system. The plurality of locations for obtaining the second temperatures and second flow rates preferably comprise locations of at least two different fluid system parts throughout the fluid system, for instance in the at least one pipe and at the least one fluid outlet of the fluid system. Preferably, the temperatures and/or flow rates are known of all parts of the fluid system, more preferably of all locations throughout the fluid system. Obtaining the temperatures and flow rates at the plurality of locations may be done by measuring, for instance by providing multiple sensing units throughout the fluid system for sensing the temperature and/or flow rate. Alternatively, or in addition thereto, obtaining the temperatures and flow rates at the plurality of locations may be done by predicting the temperatures and flow rates based on the first temperature and first flow rate making use of a thermohydraulic model of different parts of the fluid system. The thermohydraulic model may be a model requiring N input parameters, such as for instance diameters of the pipe, length of the pipe, flow profile of the pipe... Preferably the number of N input parameters may be reduced by taking into account previous input parameters, for instance deriving the length of the pipe and diameters based on the number of chambers of the fluid system,...

By way of illustration, embodiments of the present invention not being limited thereto, standard and optional features of the controller will further be described for exemplary embodiments.

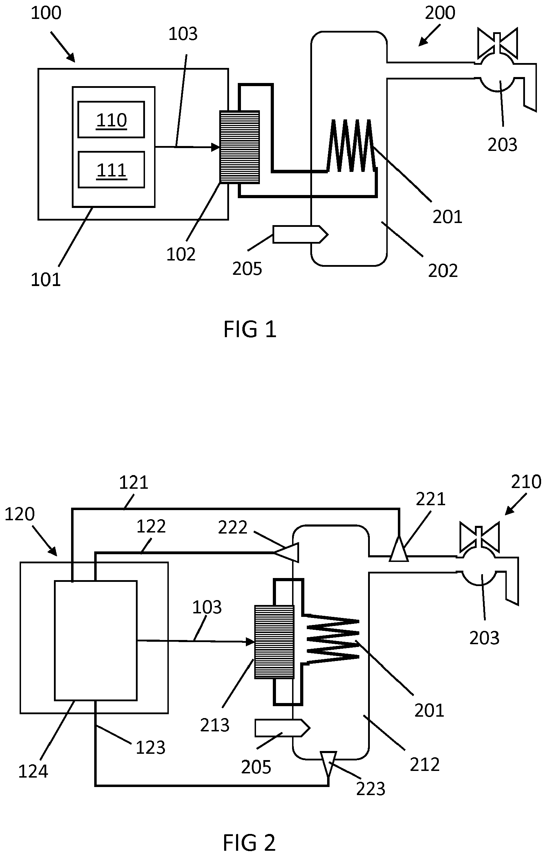

The control unit 100 shown in FIG 1 may be for example also be referred to as a controller. The control unit 100 refers to the system including the modelling module 101 and the driving system for controlling the de-bacterisation unit and the production unit. It therefore is suited for controlling a production unit over time. The module 101 includes a model of bacterial growth in the fluid in a fluid system and in advantageous embodiments also a model of bacterial growth in biofilm present in the fluid system 200. Thus, the fluid system itself is taken into account in the model. The models may be implemented in a memory module 111.

According to at least some embodiments, the control unit may be adapted for taking into account and actively using modelling of the bacterial growth and bacteria population at temperatures lying in a range between a temperature below which the bacteria are in a dormant state and a temperature above which bacteria start being killed, such as for example for Legionella at a temperature between 20°C and 45°C, e.g. lying between 25°C and 35°C. By using this intermediate temperature range, accurate modelling of bacterial growth both in the fluid and in the biofilms in the system is possible, allowing for example accurate modeling as function of time. This provides accurate information for controlling bacteria concentration in a dynamic way in a system, using the modeling information.

The control unit 100 may, in some embodiments, include means 102 to control or regulate the activation and deactivation of a heater 201 (which may optionally be part of a boiler 202 in a DHW system). For example, the module may include an output 103 for sending control signals and activate/deactivate the de-bacterisation unit, e.g. heater, 201. For example, in some embodiments, the means 102 includes a temperature regulator connected to the output 103 of the module, so as to receive signals from the module and regulate the heater according to these signals. FIG 2 shows an alternative in which the regulator is included in the boiler, rather than in the control unit 100. Further features, such as a power source for powering the heater 201 may be included as known to the skilled person. For example, the control unit of the present invention controls the activation of the heater by powering it up, for example in sequences, pulses, or heating periods. In some embodiments, the means 102 to control activation/deactivation is a switch. As indicated above, in other embodiments, the deactivation unit may be different from a heater, e.g. may be based on chemical, electrochemical or physical principles for reducing bacteria.

The activation or deactivation of the thermal treatment is performed on basis of the dynamic bacterial model used in the module 101, for example in a memory unit 110 of the module. The module may include processing means 111 for obtaining a simulation of bacterial behavior based on the model. For example, a processing unit or processor may include hardware and/or software for performing simulations of the bacterial activity and growth in the fluid distribution systems, according to the models included in the module. The results of the simulation may result in unacceptable amounts of bacteria in the fluid, so said activation may take place in order to reduce the biological activity simulated by the models. The simulation may be running continuously, may be periodic, and/or may take into account dynamic growth of the bacterial population with time. Thus, the results of the simulation may also change dynamically with time, and for example no heating may take place if the simulation shows that bacterial growth does not surpass a predetermined threshold. This allows saving energy. For example, the models may include a model of the dynamic growth of bacteria in biofilm taking into account bacterial saturation of the biofilm. The activation of thermal treatments can be tailored dynamically depending on the growth. Growth and expansion of the biofilm itself may also be taken in to account, so the need of thermal treatments (thus, the need of activating the heater for obtaining pasteurization temperatures in the fluid) may be lower in newly installed distribution systems than in the same system after a month or a year of usage, as the growth and expansion of the biofilm is taken into account throughout the fluid distribution system.

In some embodiments, the control unit is adapted to control the heating up of the fluid so as to control bacterial concentration below a predetermined threshold in the fluid in contact with the exterior of the system, for example in a fluid interchange portion 203 of the system (such as water exiting through a tap in a hot water distribution system, or vapor exiting a cooling tower in an air conditioning system). Additionally, in embodiments of the present invention for controlling temperature of water in DHW systems, the control unit may be adapted in some embodiments to provide a set point temperature resulting a tap temperature which gives sufficient comfort (e.g. between 37°C and 45°C, for example 45°C).

A further fluid interchange portion 205 may be an external source of water. The intake of water may be from a water supply network, a river, etc. Water intake (e.g. the regulation of the interchange portion 205 for water intake) may be taken into account in the models of the control unit.

In some embodiments, the control unit is adapted to control more than one heater. More heaters may be included in the distribution system, for example for heating up parts of the fluid distribution system. For instance, portions of a system with high tendency to develop biofilm and bacteria, such as dead pipe-ends, water reservoirs, and in general parts of a system prone to stagnation, may include extra heaters. The one or more heaters also may be a combination of more production systems, such as solar collectors, heat pumps, etc.

In some embodiments, the at least one heater includes a heater of a heating or cooling system, heat exchanger, and/or cooling tower. For example, a heater may be included in a cooling tower, or in a drip tray and/or humidifier of an air conditioning system. In these cases, the vapor outlet and/or the outlet for condensed water (such as a cooling tower) may be included in the models as the fluid interchange portion 203.

The module 101 is preferably a programmable module, which can be programmed for a specific fluid distribution system, and/or re-programmed, advantageously taking into account changes of the distribution system (due to e.g. renovations, substitutions, etc.). In particular, the memory unit 110 may be loaded with bacterial growth models. It may be a reprogrammable memory, such as ROM, EPROM, EEPROM... The memory unit 110 may include an interface or data input for re-programmability.

In FIG 2 it is shown an exemplary control unit 120 (e.g. the module of the control unit) including one or more inputs 121, 122, 123 for sensing means 221, 222, 223 (such as sensors). The models of bacterial growth in the module 124 may take into account such inputs from the fluid distribution system 210. The sensing means 221, 222, 223 may sense various parameters such as temperature, flow rate, etc. in different portions of the fluid distribution system, such as a bottom and/or upper portion of a boiler or water tank, one or more pipes, one or more fluid interchange portions, the area surrounding a heater for detecting the actual temperature provided, etc. Volume of fluid interchanged (entering and/or exiting the system) can also be measured and taken into account in the model.

In this case, as indicated earlier, the regulator 213 is part of the external boiler 212, and the control unit 120 can be adapted to control said regulator (e.g. via the output 103).

Including feedback from sensing means 221, 222, 223 (e.g. temperature sensors, flow rate sensors, etc.) may improve the simulations, by adjusting the models and simulations to dynamic changes of the system, temperature of the system and changes thereof, utilization of the fluid (e.g. activation of a tap, of a ventilation system or of a heating system, etc.), in real time. Further, the module may include a programmability interface, or an input with access to information therefrom, so the control unit can use the information for controlling the fluid distribution system for starting thermal treatment for decontamination. For example, a programmable interface may be used to program activation of a heating system, HVAC system, or the like. The control unit may have access to such information, and activate the heater ahead of time, for that the bacterial concentration is below the predetermined threshold. Alternatively or additionally, the module may include a predictive algorithm, for example based on behavioral learning, extracting behavior trends of usage of the system, and using such information for providing thermal treatment in a timed way, e.g. close to the predicted water usage event. Behavior trends may include typical moments in time of hot water use, typical amounts of hot water used, etc. Alternatively or in addition thereto, the control unit may, depending on the outcome of the predictive algorithm or after a predetermined time period, activate one or more fluid outlets, e.g. one or more tap points. Activating one or more fluid outlets may comprise, sending the fluid through the fluid system, including the fluid outlet and the fluid outlet pipe. In the example of tap points, activating one or more tap points may comprise flushing the outlet pipe and tap point by sending the water/fluid there through for a predetermined time period, for instance during one minute.

The module of the control unit includes models of bacterial activity and growth which can be adapted to any of these systems. Thus, it is advantageous that the module can be programmable, so simulation models can be loaded to the module. In fact, the control unit of the present invention can be included in an existing fluid distribution system, by programming the module of the control unit and installing the control unit in the system, e.g. connecting the control unit to a heater of the system (e.g. the boiler of a DHW, or a heater or condenser of a heating system).

A control unit according to embodiments of the first aspect can be included in general to any system which manipulates fluids where bacteria may grow. For example it can be included in a water distribution system, such as a DHW, aquaculture systems, industrial systems, purification and water treatment plants, and other systems for transporting water intended for direct consumption. It can be included in a fluid distribution system, such as heating and cooling systems, for example an air conditioning system, ventilation system, cooling system, or heating system, and any other system for controlling temperature and/or humidity. However, these systems do not limit the present invention, and it could be included in other systems.

Further, the present invention may include a fluid distribution system 200 comprising the control unit 100, 120 of the first aspect of the present invention. The fluid distribution system may be any of the mentioned systems (water distribution systems, systems for controlling temperature and/or humidity, etc.), including means to control the fluid temperature, such as a heater.

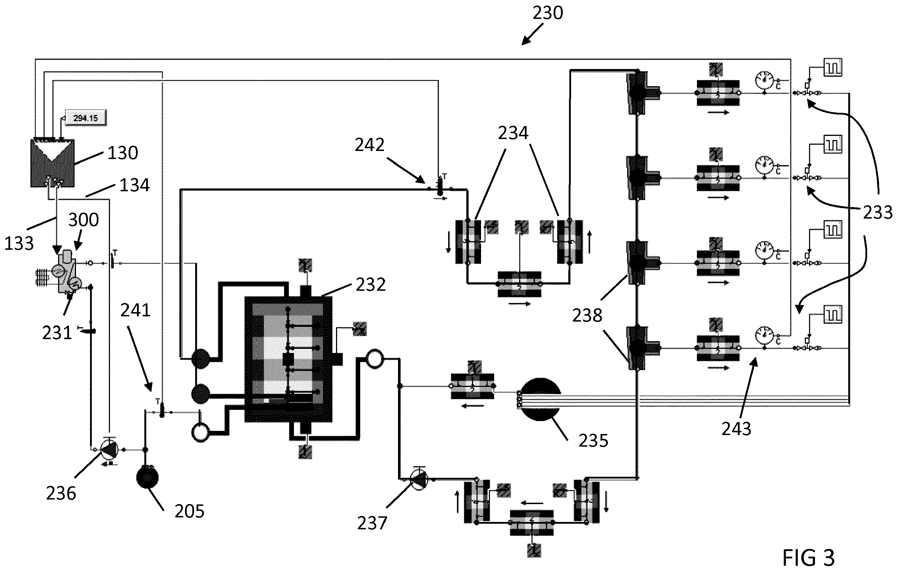

FIG 3 shows an exemplary embodiment of such fluid distribution system 230 comprising a control unit 130, for controlling activation and deactivation of a heater 231. The heater may be included in a heater element 300, such as a heat pump. The control unit may 130 may include an output 133 which can send signals to control the heater element 300. The hot water is stored in a storage tank, which is shown as a schematic representation 232 of the model used by the control unit. In other embodiments, for example in the case of the boiler 212 of FIG 2, the regulator and heater are integrated with the tank. Four taps 233 are shown as fluid interchange portions which can expel water to the exterior. The pipes are shown as a schematic representation 234 being components that can be modelled within the system. Furthermore, the expansion barrel 205 is shown, as well as the cold water 235 that enters the boiler. The model elements will be discussed in the sections "pipe model customization" and "boiler model customization" below.

Other elements such as pumps 236, 237 may be added where suitable, and taken into account in the model. The control unit 130 may include an output 134 for controlling a pump 236 for introducing water from one point, in this case a heat pump, to the heater element 300, so it can be heated in the heater 231 and 232. Tempering valves can also be included, for mixing cold and hot water at the tap.

The control unit 100 includes a module which can run (e.g. continuously) an integrated thermohydraulic and biologic model of the DHW system in the background. The model includes separate biologic models for the growth of bacteria (e.g. *L. pneumophila*) both in water and in the biofilm, in the different parts of the fluid distribution systems. These are represented as modelled pipe portions 234 (for example) and modelled tank 232. Both tap temperature (hydraulic model) and *L. pneumophila* concentration (biologic model) at the taps are predicted. The set point temperature is set to a value so as to reduce energy consumption, optionally ensuring a sufficient comfort level for the tap temperature, while limiting the concentration of *L. pneumophila* bacteria at the taps to a maximum value, for example a value of of 1000CFU/L.

If the simulated concentration at at least one of the taps exceeds the predetermined maximum value, e.g. 1000CFU/L, the control unit may be programmed to change the set point of the heater to a higher temperature (for example to a temperature from 45°C to 70°C) and optionally to start the pump (or prolongs the duration of the mass flow, if the pump was already on) until a concentration below a certain value, e.g. 25CFU/L is simulated at all taps.

The module of the control unit may further comprise a timer, the timer being programmed for driving the debacterisation unit (201) so as to reduce bacterial concentration at the at least one fluid outlet in the fluid system (200, 210, 230) when a predetermined time period is exceeded .

Optional temperature sensors 241, 242 may be placed for example at an inlet of the tank, and/or at different points of the distribution system. Flow sensors 243 can be placed also at different portions of the distribution system, for example at the taps 233. These sensors may send measurement signals to the control unit 130 and taken into account in the model, as explained with reference to FIG 2.

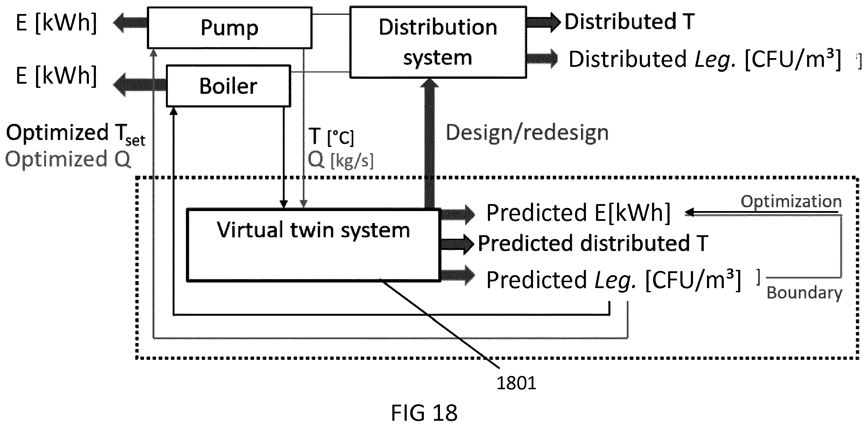

Model-based control may be performed through the creation of a virtual twin simulation model of the real system. Temperatures and flow rate in the system are monitored in real time, this data is used in the simulation model which takes into account the dynamics of the system (thermohydraulic and biologic) to predict the amount of bacteria (e.g. *Legionella pneumophila*) at the taps. This will be explained with reference to FIG 18.

The models of bacterial growth may be stored in hardware and/or software, for example in a database of the module, or in a library. A processing unit may be included, for simulating the process and for executing at least some steps of a method for controlling temperature of a fluid in a system. In the following, details of the models and simulation processes will be discussed as implementation of such method for controlling the temperature of a fluid in order to suppress bacterial activity, applicable in particular for *Legionella* genus (but applicable in other cases).

The present invention also relates to a circulation or distribution system comprising a controller as described above.

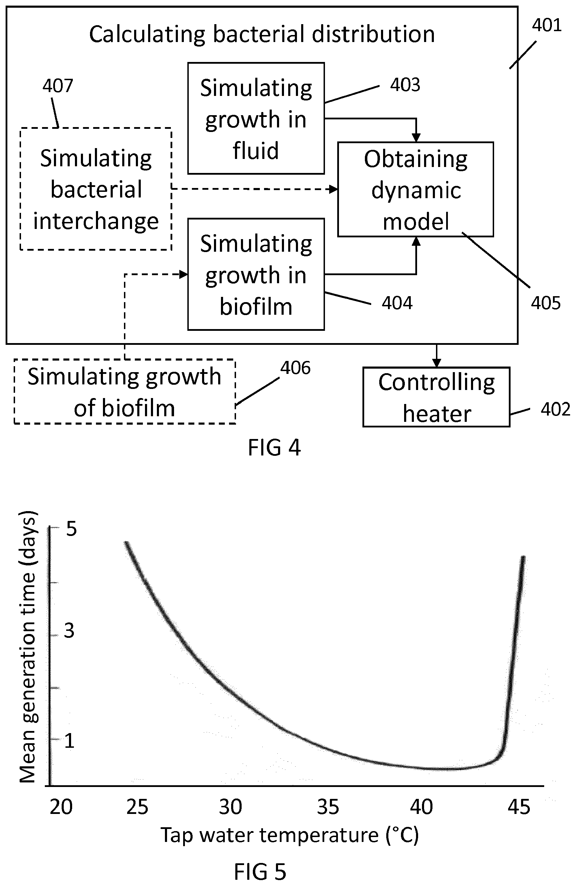

In a second aspect, the present invention includes such method of controlling the temperature of a fluid in a fluid distribution system, for suppressing bacterial activity in said fluid. The outline of the method is shown in FIG 4. It may for example be implemented in a system as shown in FIG. 18, although embodiments of the present invention are not limited thereto. It includes calculating 401 the distribution of bacteria based on models of bacterial growth in the fluid and in the biofilm, taking into account the fluid distribution system itself and its elements, the fluid therein and the bacterial film therein. The method also includes heating fluid in the fluid distribution system, e.g. by controlling 402 a heater in the distribution system. The heating is performed based on the results of the dynamic modelling, in order to control bacterial activity in the fluid. For example, activation of a heater may be provided if the simulation results in bacterial growth to a level over a predetermined threshold. The levels are simulated for example by simulating 403 the growth of bacteria in the fluid, simulating the growth in the biofilm, and obtaining the dynamic model. Optionally, simulating 406 the growth of biofilm can be done, as well as simulating 407 bacterial interchange between biofilm and water. Activation of the heater may be done during a variable period, and at a sequence and temperature such that bacterial activity (e.g. growth) is suppressed by killing bacteria, e.g. by pasteurization. Thus, bacterial control and removal is done in an efficient manner, when the results of dynamic simulation reveal the necessity, instead of periodically at fixed time intervals in time. The simulation model allows the control unit to provide a required thermal disinfection measures while keeping an equilibrium between energy efficiency and healthy buildings.

In some embodiments, the simulation may take into account behavior of the users of the system, such that prediction can be performed. The methods may be adapted for controlling systems according to predicted results, taking into account the behavior of the users.

The biological growth models may include a number of sub-equations related to growth and transport of bacteria (e.g. *Legionella pneumophila*) in water, bacterial growth in biofilm; and optionally biofilm growth and bacteria transport between biofilm and water.

The following exemplary model is shown for growth of *Legionella pneumophila* in DHW systems, but the skilled person could adapt it to any other fluid distribution system, including HVAC systems for example, and to any other suitable bacteria or infecting organism.

**Exemplary model of bacterial growth in water.**

The proliferation of *L. pneumophila* in water is modelled as a pollutant with a variable source term in different domestic hot water components, for example pipes and boilers. Based on a prior studies, the main parameters that have an impact on the multiplication of *L. pneumophila* bacteria are selected and added to the model as equations. This includes the equations of dependency between *Legionella* growth and water temperature and flow conditions.

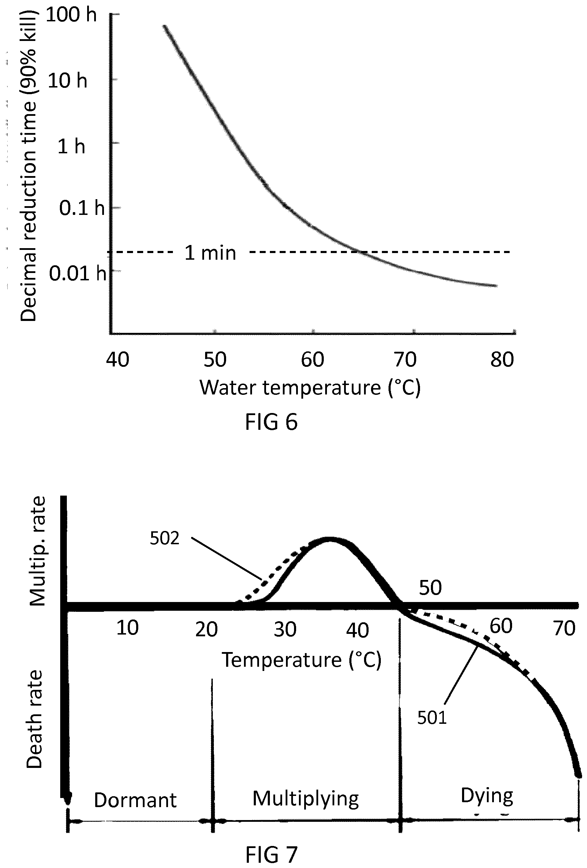

Multiplication of *L. pneumophila* is dependent on water temperature and flow rate, as well as nutrient availability (Völker et al., 2015). At temperatures below 20°C, the bacteria become dormant but remain viable for months. The bacteria grow best at temperatures between 20°C and 45°C with an optimum around 35°C-41°C. Beyond 45°C, pasteurization starts and higher temperatures will eventually kill the organism (Brundrett, 1992). This can be seen on FIG 5, showing an estimation of mean generation time (time to double the number of cells) of *L. pneumophila* in tap water as a function of temperature, based on data from Yee and Wadowsky (1982) from experiments on unsterilized tap water, and in FIG 6, showing the change in decimal reduction time (the time to reach 90% reduction in *L. pneumophila*) with temperature, based on data from laboratory experiments (Sanden et al., 1989, Schulze-Röbbecke et al., 1987, Stout et al., 1986, Dennis et al., 1984), but is consistent with field data (Groothuis et al., 1985). FIG 5 shows that the time to double the number of *L. pneumophila* cells in water is less than half a day at 41°C, but at 70°C, 90% of *L. pneumophila* in water gets killed in less than a minute (shown in FIG 6). The death rate at any temperature is proportional to the number of living cells present (Reddish, 1957; Sykes, 1965; Allwood and Russell, 1970) *(Equation (1))*.

$$\text{Death rate: } dC/dt = (T) \cdot Ct \qquad\qquad (1)$$

$$\text{Number of cells: } Ct = C0 \cdot e^{\wedge}(\pm B(T) \cdot t)$$

With C0 [CFU/m$^3$] being the start concentration of *L. pneumophila* in water entering the system, Ct [CFU/m$^3$] the concentration of *L. pneumophila* in water at time t, dC/dt- being the variation of concentration of *L. pneumophila* over time t [s], and B(T) being a function depending on water temperature, species of the organism and chemical nature of the water.

**Influence of biofilm**

Even if an uncritical natural concentration of *L. pneumophila* enters the building, if the conditions in these man-made environments are optimal for bacterial growth, it can reach dangerous concentrations. If bacteria would appear only in water, it could be flushed out of the system during water usage with no time to grow. However DHW system components do not only contain water, but also biofilm layer which may be as thin as a single cell attached to the surface (<5 $\mu$m) and as thick as 1000 $\mu$m (Murga et al., 1995). Wherever there is water, biofilm growth can occur, for example in storage tanks, humidifiers and cooling towers. Biofilms can grow very easily in domestic hot water pipes since they provide a moist and warm environment for the biofilm to thrive; 95% of *Legionella* may be surface-associated (Flemming, 2002). The biofilm forms a protective layer for the bacteria which allows them to grow and multiply within the biofilm. Several authors have reported that *L. pneumophila* bacteria that live in a biofilm are more resistant to environmental stress and water decontamination treatments (Cervero-Aragó, 2015; Fields et al., 1984; Sanderson et al., 1997; Sutherland, 2001; Borella et al., 2004; Russell, 2003; Van Der Kooij et al., 2005), this means for example a better resistance of *L. pneumophila* to higher temperatures when present in a biofilm. Secondly, *L. pneumophila* is able to infect and replicate inside protozoans. This means that these bacteria can survive as an intracellular parasite of free-living amoebae (Farhat et al. 2012, Altschul et al. 1990, Kilvington et al. 1990, Rowbotham 1980, Thomas et al. 2004, Wéry et al. 2008). Free-living amoebae are eukaryotic microorganisms, commonly found in drinking water systems. This association established between *L. pneumophila* and amoebae in biofilms in domestic hot water systems indicates an increased health risk. The models of the present invention may not only take into account bacteria living in water or biofilm, but also infecting amobae living in water or biofilm.

Cervero-Aragó et al. (2015) tested the effect of temperature on a *L. pneumophila* strain and two amoebae strains under controlled laboratory conditions. To determine the influence of the relationship between *L. pneumophila* and amoebae *Acanthamoeba species* and *Acanthamoeba Castellani* on the treatment effectiveness, inactivation models of the bacteria-associated amoeba were constructed and compared to the models obtained for the free living bacteria state. The thermal treatment was tested at four experimental temperatures: 50°C, 55°C, 60°C and 70°C, for various exposure times and applied to *L. pneumophila* under controlled laboratory conditions. Table 1 shows the results and the R$^2$ values showing the robustness of the regression models (adapted from Cervero-Aragó et al., 2015).

Table 1. Calculated time for a 4-log reduction of *L. pneumophila serogroup 1 environmentally* associated with *Acanthamoeba Castellani CCAP 1534/2* and *Acanthamoeba species 155* after the exposure to different temperatures.

| T. effect on Legionella in water | 50°C \| R$^2$ | 55°C \| R$^2$ | 60°C \| R$^2$ | 70°C \| R$^2$ |
|---|---|---|---|---|
| *L. pneumophila* sg. 1 env (Axenic) | 46 \| 0.84 | 8 \| 0.98 | 4 \| 0.86 | 0.61 \| 0.82 |
| T. effect on Amoebae associated Legionella | | | | |

(continued)

| T. effect on Legionella in water | 50°C \| $R^2$ | 55°C \| $R^2$ | 60°C \| $R^2$ | 70°C \| $R^2$ |
|---|---|---|---|---|
| L. pneumophila sg. 1 env - CCAP 1534/2 | 825 \| 0.56 | 45 \| 0.84 | 5 \| 0.99 | 0.45 \| 0.82 |
| L. pneumophila sg. 1 env - Acanthamoeba | 664 \| 0.95 | 51 \| 0.95 | 5 \| 0.73 | 0.5 \| 0.92 |

The time required for the cultivability of *L. pneumophila* to reach a 4-log reduction for the axenic *L. pneumophila serogroup 1* was 46 minutes at 50°C, 8 minutes at 55°C, 4 minutes at 60°C and 0.61 minutes at 70°C (*Table 1*). When *L. pneumophila* was associated with amoeba, either *Acanthamoeba spp.* or *A. Castellani*, these times ranged from 664-825 minutes at 50°C, 51-45 minutes at 55°C, 5 minutes at 60°C and 0.50-0.45 minutes at 70°C, respectively. The effectiveness of the thermal treatment compared to the free form was reduced. At 50°C, the bacterial resistance was increased between 14 and 18 fold and at 55°C it was increased between 5 and 6 fold. Thus, it seems that *Acanthamoeba species* and *Acanthamoeba Castellani* play a protective role for the *L. pneumophila* bacteria at temperatures below 60°C, but at higher temperatures, its protection dramatically decreases (Cervero-Aragó et al., 2015).

FIG 7 shows the temperature dependent growth function of *L. pneumophila* bacteria in water (full curve 501) and in biofilm (dotted curve 502), determined based on existing studies and models (Cervero-Aragó et al., 2015) showing the time required to reach a 4-log reduction for the axenic *L. pneumophila serogroup* 1, when *L. pneumophila* was associated with either *Acanthamoeba species* or *Acanthamoeba Castellani* (in biofilm). The results of the growth in water are comparable to the ones shown in Table 1 for *L. pneumophila* in water (axenic). The most negative data (slowest starvation) of the Legionella-amoebae association is plotted into the dotted curve. Whereas in the state of the art typically only use was made of information regarding those temperature ranges where the bacteria were dormant or dying, in the present invention use is also made in intermediate temperature ranges. Although the present invention uses information obtained from the activity and growth between 20 and 40°C (or higher), the models can include information of activity under 20°C or above 40°C.

**Model of growth in fluid distribution system**

These models can be expanded into a full fluid distribution system model. The following discussion relates to an expansion of the bacterial model growth to *Legionella* growth in water in a pipe, and later in a tank. For this, equations need to be added to the hydraulic model. Mass balance equations, which predicts *L. pneumophila* growth in water, need to be coupled to a pipe component which typically can be taken into account in the modelling performed (*Equation 2, Equation 3*):

$$(Ct+1-Ct)\cdot Vp/\Delta t = Ct,\cdot Ain\cdot \vec{v}\, t,in/\rho - Ct,out\cdot Aout\cdot \vec{v}\, t,out/\rho + Growth + Biofilm \ (2)$$

$$Vp\cdot \rho\cdot dC/dt = Ct,\cdot Qt,in - Ct,out\cdot Qt,out + Vp\cdot \rho\cdot \dot{m}t + h\cdot (Ct,in - Cb,t,out)$$

With:

$$Qt, = Qt,out \qquad\qquad (3)$$

$$\dot{m}t = C0\cdot ln\,(2)/y\cdot e^{\wedge}(ln\,(2)\cdot t/y) \qquad\qquad (4)$$

With:

C0 [CFU/m$^3$] - Start concentration of *L. pneumophila* in water entering the system
Ct [CFU/m$^3$] - Concentration of *L. pneumophila* in water at time t
Ct,in [CFU/m$^3$] - Concentration of *L. pneumophila* in water entering the system
Ct,out [CFU/m$^3$] - Concentration of *L. pneumophila* in water interchanged (leaving the system, e.g. through an interchange portion 203, e.g. a tap).
Cb,t,out [CFU/m$^3$] Concentration of *L. pneumophila* in biofilm at time t

dC/dt Changing concentration of *L. pneumophila* over time
Qt,in [kg/s] - Mass flow rate of *L. pneumophila* in water entering the system
Qt,out [kg/s] - Mass flow rate of *L. pneumophila* in water interchanged
h [kg/s] - Mass flow rate of *L. pneumophila* entering/leaving the biofilm
Vp [m$^3$] Volume of water in pipe
$\rho$ [kg/m$^3$] Mass density of mixture
*v t* [m/s] Mass-average velocity for multicomponent mixture
T [K] Absolute temperature

Growth coefficient y is a time constant [s] which predict growth or death of bacteria in water. In equation 4, y is dependent on water temperature in the pipe component. y was originally split up in y1 and y2 (Attachment 1). y1 is the mean generation time in water (time to double the number of cells), y2 is the decimal reduction time in water (time to reduce Legionella with 90%, 10% remains).

The split model of bacterial growth in **water** in a pipe is shown in *Equation 4A* and *4B*.

$$\dot{m}t = C0 \cdot ln\,(2)y1 \cdot e^{\wedge}(ln\,(2)/y1 \cdot t)\ \text{(growth)} \tag{4A}$$

$$\dot{m}t = C0 \cdot ln\,(1/10)y2 \cdot e\,ln\,(1/10)y2 \cdot t\,\text{(starvation)} \tag{4B}$$

With $\dot{m}t$ Changing concentration of *Legionella pneumophila* over time

Growth coefficients *y1 and y2* are time constants [s] to predict growth (*y1*) or death (*y2*) of *Legionella pneumophila* bacteria in water. *y1* in *Equation 4A* and *y2* in *Equation 4B* are dependent on the temperature *T* of water in the pipe component. *y1* is the mean generation time in water (time to double the number of cells), *y2* is the decimal reduction time in water (time to reduce *Legionella* with 90%, 10% remains). *y1* is the mathematical translation of FIG 5 and *y2* of *FIG 6*. Equations of *y1* and *y2* are made for *Legionella pneumophila* in water (*Equation 5A*). It is to be noted that the equations given below are determined based on a particular experiment and that these are obtained by best fitting. It will be clear to the person skilled in the art that equations expressing a similar behavior, may also be used, e.g. when less accurate results would be required.

$$T \leq 20°C\ y1 = 1,000,000$$

$$20°C < T < 25°C\ y1 = -128,996.48*T+3,579,929.6$$

$$25°C \leq T < 44°C\ y1 = 2.9988090226*T4-473.8259729333*T3$$

$$+28,717.2386165937*T2 -793,367.9422568690*T$$

$$+8,473,063.073695$$

$$44°C \leq T < 45°C\ y1 = 230,040*T-10,082,880$$

$$45°C \leq T < 48°C\ y2 = 139,351,910,528,172*1025*T-20.5367087417573$$

$$48°C \leq T < 70°C\ y2 = 13,935,191,054,869*1026*T-20.5367087418$$

$$70°C \leq T < 80°C\ y2 = -1.6668*T+151.056$$

$$T \geq 80°C\ y2 = 17.716 \tag{5A}$$

The non-split equations of y are made for *L. pneumophila* in water (Equation 5):

$$T \leq 20°C \qquad y = 1,000,000$$

$$20°C < T < 25°C \qquad y = -128,996.48*T+3,579,929.6$$

$$25°C \leq T < 44°C \qquad y = 2.9988090226*T4-473.8259729333*T3$$

$$+28,717.2386165937*T2 -793,367.9422568690*T$$

$$+8,473,063.073695$$

$$44°C \leq T < 45°C \qquad y = 230,040*T-10,082,880$$

$$45°C \leq T < 48°C \qquad y = -4.62917026659765*1036*T-20.5367087417573$$

$$48°C \leq T < 70°C \qquad y = -4.62917026727924*1039*T-20.5367087418$$

$$70°C \leq T < 80°C \qquad y = 5.53698974855826*T-501.797170301305$$

$$T \geq 80°C \qquad y = -58.8512781290245 \qquad (5)$$

Biofilm in a pipe is also taken into account in the model.

To model *Legionella* growth in biofilm in a pipe, equations need to be added to the hydraulic model in a similar way as for growth in water. Following mass balance equations, which predicts *Legionella pneumophila* growth in biofilm, needs to be coupled to an existing pipe component (*Equation 6, Equation 7*).

$$(Cb,t+1-Cb,t) \cdot Vb/\Delta t = Ct, \cdot (Ain \cdot \vec{v}\,t,in/\rho) - Cb,t,out \cdot (Ab,out \cdot \vec{v}\,b,t,out/\rho) + Growth$$

$$(6)$$

$$Vb \cdot \rho \cdot dCb,/dt = h \cdot (Ct,in-Cb,t,out) + Vb \cdot \rho \cdot \dot{m}b,t$$

With:

$$Qt,in=Qt,out \qquad\qquad (7)$$

$$\dot{m}b,t=C0 \cdot (\ln(2)/y3) \cdot e^{\wedge}(\ln(2) \cdot t/y3) \qquad\qquad (8)$$

$$\dot{m}b,t=C0 \cdot (\ln(1/10)/y4) \cdot e^{\wedge}(\ln(1/10) \cdot t/y4) \qquad\qquad (\text{starvation})$$

$$\dot{m}b,t=C0 \cdot (\ln(1/10,000)/y5) \cdot e^{\wedge}(\ln((1/10,000) \cdot t/y5) \qquad\qquad (\text{starvation})$$

With $Cb,t$ [CFU/m$^3$] being the concentration of *L. pneumophila* in biofilm at time t, $Qb,t$ [kg/s] the mass flow rate of *L. pneumophila* entering/leaving the biofilm, Vb [m$^3$] the volume of biofilm in pipe.

Growth coefficient y is a function to predict growth or death of *Legionella pneumophila* in biofilm. *y* in *Equation 8* is dependent on water temperature *T* in the pipe component. As before, the model of *Legionella* growth in **biofilm** in a pipe was originally split up in *Equation 7A*, *7B* and *7C*.

$$\dot{m}b,t=C0 \cdot \ln(2)y3 \cdot e^{\wedge}\ln(2) \cdot t/y3) \text{ (growth)} \qquad\qquad (7A)$$

$$\dot{m}b,t=C0 \cdot \ln(1/10)y4 \cdot e^{\wedge}\ln(1/10) \cdot t/y4)(\text{starvation}) \qquad\qquad (7B)$$

$$\dot{m}b,t=C0 \cdot \ln(1/10,000)y5 \cdot e^{\wedge}\ln(1/10,000) \cdot t/y5) \text{ (starvation)} \qquad\qquad (7C)$$

Growth coefficients *y3, y4 and y5* are functions to predict growth (*y3*) or death (*y4, y5*) of *Legionella pneumophila* in biofilm. *y3* in *Equation 7A*, *y4* in *Equation 7B* and *y5* in *Equation 7C* are dependent on the temperature *T* of water in the pipe component. *y3* is the mean generation time in biofilm (time to double the number of cells), *y4* is the decimal reduction time in biofilm (time to reduce *Legionella* with 90%, 10% remains) and *y5* is the 4-log reduction time in biofilm (time to reduce *Legionella* with 99.99%, 0.01% remains). Growth coefficient *y5* is added for growth of *Legionella pneumophila* in biofilm based on the results of Cervero-Aragó (2015). *Equation 8A* are the equations of *y3, y4* and *y5* for *Legionella pneumophila* in biofilm. It is to be noted that the equations given below are determined based on a particular experiment and that these are obtained by best fitting. It will be clear to the person skilled in the art that equations expressing a similar behavior, may also be used, e.g. when less accurate results would be required.

$$T \leq 20°C\ y3 = 1,000,000$$

$$20°C < T < 25°C\ y3 = -128,996.48*T + 3,579,929.6$$

$$25°C \leq T < 44°C\ y3 = 2.9988090226*T4 - 473.8259729333*T3$$

$$+28,717.2386165937*T2 - 793,367.9422568690*T$$

$$+8,473,063.073695$$

$$44°C \leq T < 45°C\ y3 = 393,120*T - 17,258,400$$

$$45°C \leq T < 50°C\ y4 = 393,120*T - 17,258,400$$

$$50°C \leq T < 70°C\ y5 = 46,412,274,253,751*1028*T - 21.8803778292$$

$$70°C \leq T < 80°C\ y5 = -1.6668*T + 151.056$$

$$T \geq 80°C\ y5 = 17.716 \tag{8A}$$

Stabilization in concentration can be implemented in the model, because the system can only hold as many bacteria as nutrients and oxygen can support. To take nutrients into account, parameter *K* is added to the mass balance equations (Verhulst-Pearl logistic equation). This population growth equation is sigmoidal (S-shaped), reaching an upper limit termed the carrying capacity, *K*, the maximum concentration of *L. pneumophila* that food and oxygen can support. Thus, the models and simulations can be advantageously dynamic, taking into account non-linearities due to presence of bacteria for growth thereof. Moreover, unsuitable initializations can be corrected by the model itself by choosing a parameter K suitable for a predetermined fluid distribution system to be used with the controller. Specifically, populations initiated at densities above K decline exponentially until they reach K, which represents the only stable equilibrium (Panikov, 1995) (*Equation 10*).

$$dC/dt = B(T) \cdot C \cdot (1 - C/K) \tag{10}$$

To take K into account equation 4A, 4B, 7A, 7B and 7C become respectively 4A', 4B', 7A', 7B' and 7C'.

$$\dot{m}_t/(\dot{m}_t - K) = C_0/(C_0 - K) \cdot e\wedge(ln\ (2) \cdot t/y1) \tag{4A'}$$

$$\dot{m}_t/(\dot{m}_t - K) = C_0/(C_0 - K) \cdot e\wedge(ln\ (1/10) \cdot t/y2) \tag{4B'}$$

$$\dot{m}_{b,t}/(\dot{m}_{b,t} - K) = C_0/(C_0 - K) \cdot e\wedge(ln\ (2) \cdot t/y3) \tag{7A'}$$

$$\dot{m}_{b,t}/(\dot{m}_{b,t} - K) = C_0/(C_0 - K) \cdot eln\ (1/10) \cdot t/y4 \tag{7B'}$$

$$\dot{m}_{b,t}/(\dot{m}_{b,t} - K) = C_0/(C_0 - K) \cdot eln\ (1/10,000) \cdot t/y5 \tag{7C'}$$

Growth coefficient *y5* is added for growth of *Legionella pneumophila* in biofilm based on the results of Cervero-Aragó (2015). *Equation* 9 are the equations of *y3*, *y4* and *y5* for *Legionella pneumophila* in biofilm.

$$T \le 20°C \ y = 1{,}000{,}000$$

$$20°C < T < 25°C \ y = -128{,}996.48*T+3{,}579{,}929.6$$

$$25°C \le T < 44°C \ y = 2.9988090226*T4-473.8259729333*T3$$

$$+28{,}717.2386165937*T2 -793{,}367.9422568690*T$$

$$+8{,}473{,}063.073695$$

$$44°C \le T < 45°C \ y = 393{,}120*T-17{,}258{,}400$$

$$45°C \le T < 50°C \ y = -1.30591637266212*106*T-5.73311638328041*107$$

$$50°C \le T < 70°C \ y = -6.16712951164611*1042*T-21.8803778292$$

$$70°C \le T < 80°C \ y = 22.147958994233*T-2007.18868120522$$

$$T \ge 80°C \ y = -235.405112516098 \tag{9}$$

Taking K into account, equation 4 and 8 become respectively 4' and 8'.

$$\dot{m}_t/(\dot{m}_t - K) = C_0/(C_0 - K) \cdot e^\wedge(ln\,(2)y \cdot t) \tag{4'}$$

$$\dot{m}_{b,t}/(\dot{m}_{b,t} - K) = C_0/(C_0 - K) \cdot e^\wedge(ln\,(2)y \cdot t) \tag{8'}$$

Although DWH systems include different components (heat exchangers, storage tanks, expansion vessels, etc.), the main part of the system consists of piping. Different existing pipe models are investigated to select useful models that can be extended with equations for simulation of bacterial growth in DHW. A suitable pipe can be applied for the simulation, by applying a suitable pipe model. Analogously, boilers can be modelled and included in the simulation.

Suitable libraries comprising building and system components for energy performance simulation can be used. Examples of such libraries are libraries developed in IEA EBC Annex 60, and existing pipe and boiler models of the standard software (e.g. Modelica (3.2.1) library, OpenIDEAS (0.3.0) library and integrated Buildings (3.0.0) library).

In examples discussed below, Modelica Dymola is used to compile the Legionella growth and system models. Dymola (Dynamic Modeling Laboratory) is suitable for modelling of various kinds of physical systems. It supports hierarchical model composition, libraries of truly reusable components, connectors and composite acausal connections. Model libraries are available in many engineering domains. Modelica uses a new modelling methodology based on object orientation and equations. The usual need for manual conversion of equations to a block diagram is removed by the use of automatic formula manipulation. Other highlights of Modelica are the ability to handle large, complex multi-engineering models, faster modelling by graphical model composition, faster simulation and symbolic pre-processing, it is open for user defined model components, it is an open interface to other programs, it is possible to see 3D animation and the simulation happens real-time. The Modelica library version 3.2.2, IDEAS 1.0.0 and Buildings 4.0.0 are used.

Some existing pipe models include DynamicPipe, StaticPipe, HeatedPipe, IsolatedPipe, Short Pipe (from Modelica 3.2.1), EmbeddedPipe, InsulatedPipe, LosslessPipe, Pipe, Pipe_HeatPort, Pipe_Insulated (from OpenIDEAS 0.3.0 library) or LosslessPipe and Pipe (from Buildings 3.0.0 library).

Modelling bacterial growth into the pipe model allows easy compiling of simulation models of different systems, e.g. by dragging and dropping the different DHW components (including bacteria growth equations) into the system model. This improves adaptation of the method to different systems and programmability and reprogrammability of the control unit.

Some of the parametric categories for modelling bacterial growth include mass balance (*Equation 11*), momentum balance (*Equation 12*) and energy balance equations (*Equation 13*). Conservation of mass is modelled with a differential continuity equation, whicle momentum balance (Newton's second law of motion) with Navier-Stokes equation for incompressible flow.

Mass balance: $\partial\rho/\partial t + \nabla\cdot\rho v = 0$            (11)

Where $\partial\rho/\partial t$ is the parameter "Trace substances". The mass balance parameter 'trace substances' indicates if the existing pipe component contains certain flow equations which make it possible to add substances to water. Addition of *Legionella* is represented by this parameter.

Momentum balance: $\rho Dv/Dt = \rho g - \nabla P + \mu\nabla^2 v$            (12)

where $\rho g$ represents gravity, $\nabla P$ represents pressure drop, and the rest of the terms represent laminar/turbulent flow, friction and material roughness. Momentum balance parameter 'gravity' defines if the pipe can be used in all directions (vertical/horizontal). A pipe model without inclusion of gravity can only be used horizontally. 'Pressure drop' inclusion influences the fluid flow, which in return influences the growth of bacteria. The momentum balance parameter 'state of the flow (laminar/turbulent)' represents flow dependency of *Legionella* growth. Momentum balance parameters like 'friction' and 'material roughness' represent the influence of biofilm and its formation, and can be used in the model of growth of *Legionella* bacteria.

Energy balance: $\nabla\cdot k\nabla T + \dot{q} + \Phi = \rho.c.v.DT/Dt$            (13)

The energy balance equation shows the relationship between heat from the soruce, heat exchange, insulation and the predefined number of segments ("nNodes") in which the pipe can be divided for the model.

Energy balance parameters (e.g. 'heat source', 'insulation') can be taken into account, allowing adaptation of the model to many fluid distribution system configurations. 'Heat exchange' is the exchange of heat with the environment, which influences the water temperature, affecting the growth or starvation of *Legionella* bacteria.

The momentum and energy balance parameters remain unchanged when *Legionella* is added to the model in the mass balance, but they may be included because they affect other parameters (such as e.g. roughness).

A model taking into account insulation of the pipes, division of the pipe into segments and roughness (so as to take into account biofilm formation and growth) can be advantageously chosen (e.g. the 'Pipe' model from the Buildings (3.0.0) library). Other parameters such as gravity or pressure drop can be added with further equations.

Besides piping, the most important part in a DHW system is the boiler. In order to model *Legionella* growth in a boiler, equations need to be added to the hydraulic model. The same mass balance equations as in the pipe model, which predict *L. pneumophila* growth in water and biofilm, need to be coupled to an existing boiler component. Existing simulation environments and libraries, using adequate pipe and boiler components, can be applied to model bacterial growth. By suitably adapting the model, it can be applied to different distribution systems, biofilms and bacterial populations.

Different existing boiler models can be extended with equations for simulation of bacterial growth in water. Exemplary boiler models are OpenTank, DrumBoiler (from Modelica 3.2.1), Boiler, StorageTank, StorageTank_OneIntHX (from OpenIDEAS 0.3.0) and BoilerPolynomial and StratifiedEnhanceInternalHex (from Buildings 3.0.0). The same parameters as for piping are taken into account.

A model which includes insulation of the boiler, segment division, heat source, pressure drop and laminar flow equations, and possibility of addition of trace substances, can be advantageously chosen. For example, the 'Stratified Enhanced Internal Hex' boiler model can be used.

Other domestic hot water components, like heat exchangers, expansion vessels, water softeners etc. can also be modelled in a similar way.

**Pipe model customization**

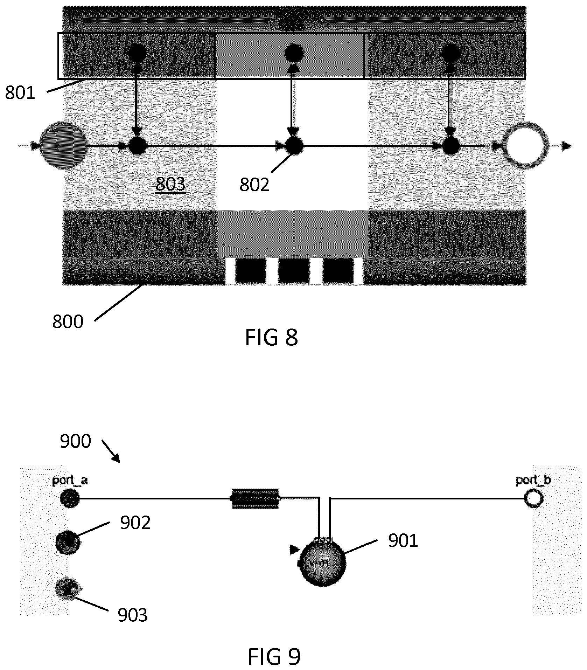

An example of modification of the Pipe model from the Buildings (3.0.0) library can be seen in FIG 8. The pipe 800 includes at its walls flat rectangles 801 which visually represent the biofilm, and the black circles 802 and arrows show the exchange of bacteria between biofilm and water 803.

While FIG 8 shows the visual additions, FIG 9 shows the diagram view 900, as thermodynamic and biologic adaptation, of the retained Pipe model from the Buildings (3.0.0) library. All fluid containing components in the Buildings (3.0.0) library includes a mixing volume 901, this is the fluid volume that contains a medium, in this application this is water with Legionella and nutrients, meaning trace substances are added to the mass balance equations. The Pipe model itself has a fluid connector (port_a), the same logic has been followed to add certain concentrations of *Legionella* and nutrients to the fluid in the pipe component. A port 902 to add a concentration of *L. pneumophila* and a port 903 to add a concentration of nutrients is added to the Pipes diagram view. Equations 2-13 are written in the ports.

**Boiler model customization**

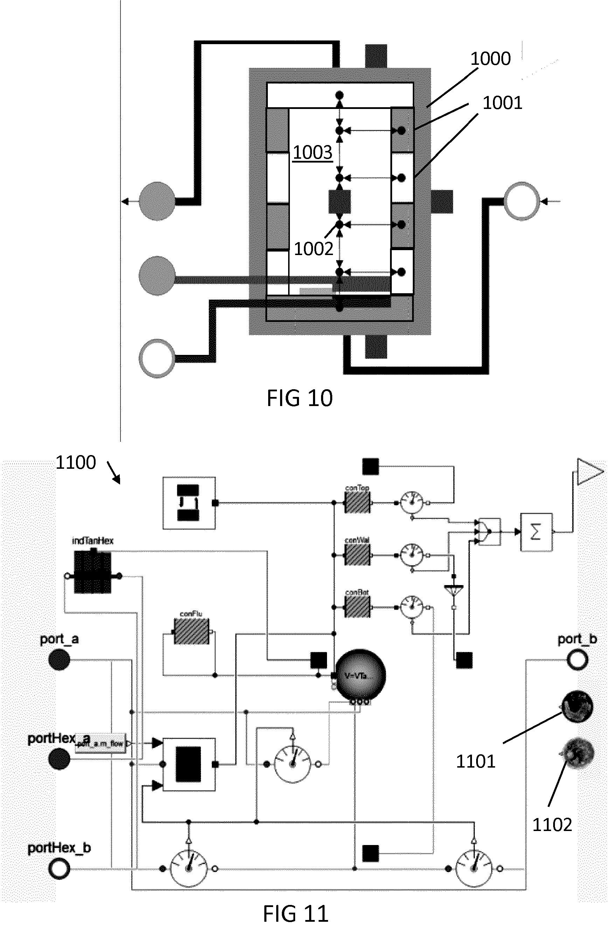

The modification of the retained StratifiedEnhancedInternalHex model from the Buildings (3.0.0) library can be seen in FIG 10 for a boiler 1000. The rectangles 1001 visually represent the addition of biofilm at the walls of the boiler 1000, and the black circles 1002 the exchange of bacteria between biofilm and water 1003 in the boiler.
While FIG 10 shows the visual additions, FIG 11 shows the diagram view of the customized boiler model, illustrating the thermodynamic and biologic adaptation of the boiler model from the Buildings (3.0.0) library, analogously to FIG 9. A port 1101 to add a concentration of *L. pneumophila* and a port 1102 to add a concentration of nutrients is added to the diagram view. Equations 2-13 are written in the ports.

**Proof of concept**

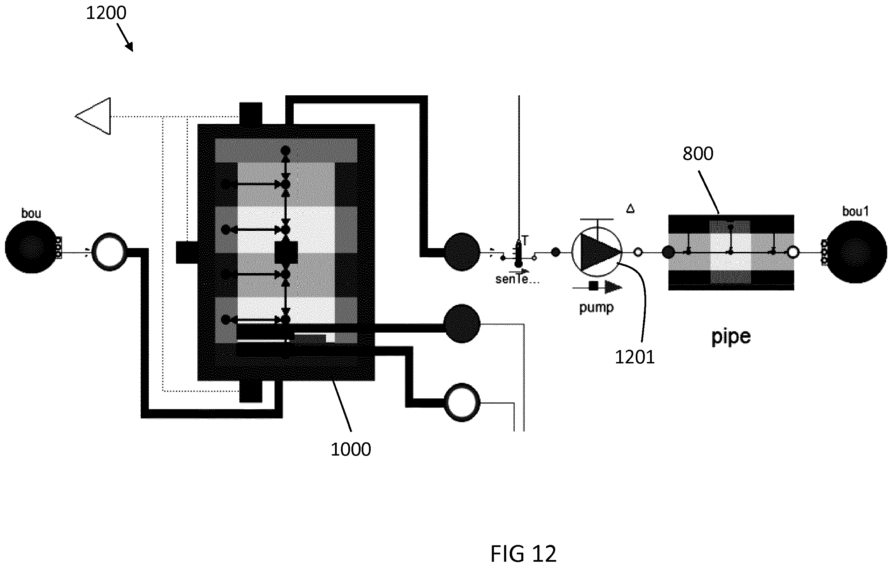

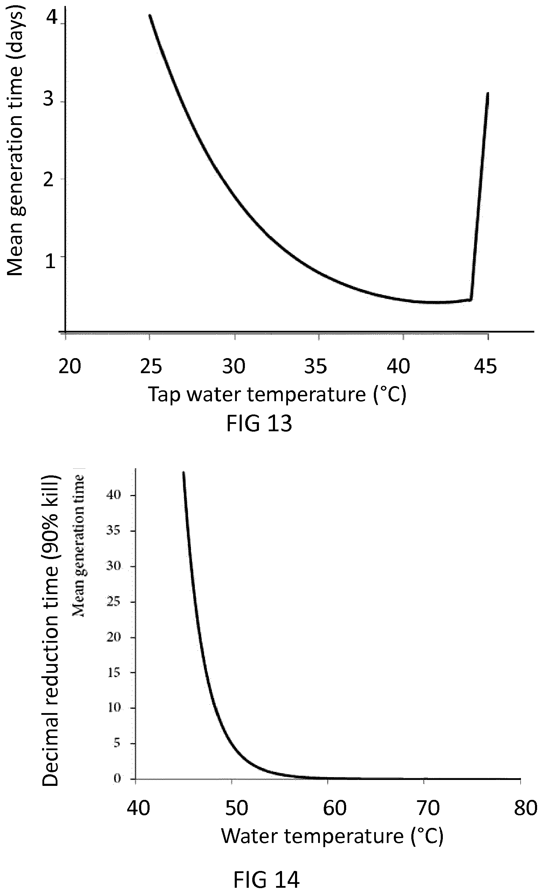

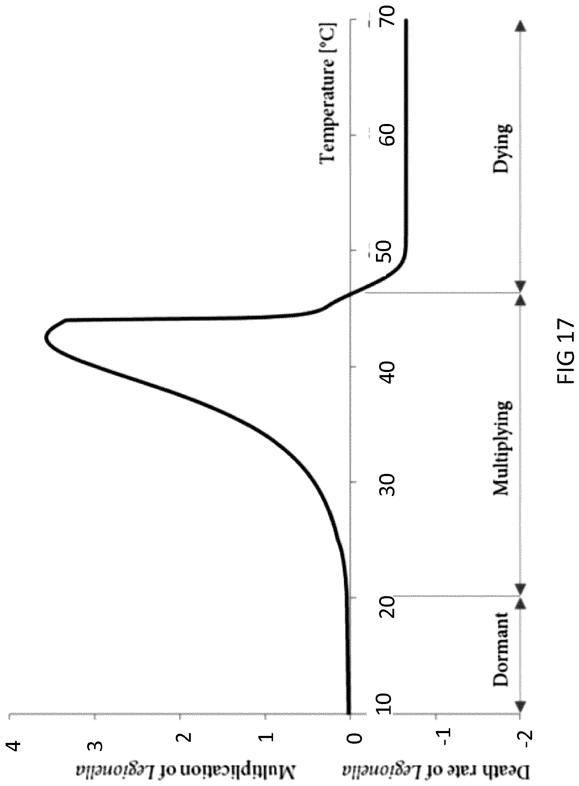

The pipe and boiler models, with addition of *L. pneumophila* growth equations in water and biofilm, can now be used to build different DHW system configurations. An exemplary simple system configuration is represented in FIG 12. The diagram 1200 shows a DHW system with one customized boiler 1100 and one pipe 800 representing the piping, both including the models. They are linked by a pump 1201.
As proven by simulating the system of FIG 12, the results in FIG 13 and 14 demonstrates that it is possible to achieve the growth/starvation curves similar to the ones of FIG 5 and FIG 6 of *L. pneumophila* in water by simulation, as well as the same curves in biofilm based on the results of *Table 1*. The temperature of the water is considered to be the same as the temperature in the biofilm.
The overall growth curve of bacteria in water (full curve 501 in FIG 5) can also be achieved by simulation as shown in FIG 17. It is to be noted that the Y axis of FIG 5 has arbitrary units, which affects the scale.
The above illustrates a simulation of the *Legionella pneumophila* growth equations in a basic model. This basic model is, where required, expanded by further implementing the customized pipe and boiler model in more complex DHW system models, and simulation results show that energy can be saved without increasing infection risk. In particular, it is possible to lower temperature requirements, thus reducing energy demand of DHW, without increasing infection risk and without compromising comfort requirements.
For example, based on the results of dynamic simulations, taking into account development of biofilm, water utilization, etc, the control unit may program a thermal shock at a variable temperature (e.g. 50 to 70 °C, the exact temperature being determined by the results of simulation), during a predetermined or variable time (e.g. during few minutes, the number of minutes being determined by the results of simulation), with a variable periodicity (e.g. every few days, the number of days being determined by the results of simulation), for staying under the critical *L. pneumophila* concentration, and avoiding unnecessary pulses when the simulations determine that the amount of bacteria is not hazardous. For example, the requirement may be a *Legionella* concentration of less than 1000 CFU/L (Colony Forming Units a liter), given as a boundary condition to the. A first simulation is necessary to determine these parameters for a specific case for calibration, and then the simulations can be repeated periodically, or continuously, or triggered by input, such as a user input or a sensor input. Previous usage of the fluid distribution system and previous thermal treatments can be taken into account for the simulations.
When implementing the adapted pipe model in the DHW recirculation system of this case study building, simulation results show that it is possible to lower the DHW production temperature from 61-64°C (current used temperature regime) to 49-51°C, while adding shock disinfection. For example, this shock can be performed every 12 days at 70°C for 3 minutes. This measure does not increase infection risk and reduces energy use by 34%. According to the simulations this measure decreases the total primary energy consumption for DHW from 238 000 kWh/year to 157 254 kWh/year. The primary energy consumption for DHW is defined as the total energy consumption for the production of DHW times the conventional conversion factor to primary energy of the energy using device (for example, times 2.5 for electricity use). The simulations may also show that after some months, the shock can be performed every fewer days, due to e.g. development of biofilm, or due to changes in usage or temperature detected by sensors.
Thus, the present invention allows controlling the temperature of hot water between 20°C and 40°C in a hot water system, reducing energy usage, while at the same time reducing the presence of bacteria by tailoring the thermal treatments in a dynamic way.
This can also be applied to HVAC systems, and a simulation model can be adapted to said systems. Simulation models also allows assessing the infection risk for *Legionella pneumophila* in the design phase. Additionally, simulations help to choose an effective thermal treatment and hydronic controls with reducing energy demand. Additionally, simulations of these dynamic models (optionally including feedback from sensors) allow dynamically adapting these thermal treatments to changes in the system and usage thereof.
The method may further comprise providing temperature measurements and/or flow measurements and adapting the simulation dynamically according to the measurements. For example, the temperature may be measured in a water tank, in a boiler, or in or along a pipe in a water transportation system (e.g. DHW system), or in the drip tray of an HVAC system, for example. The flow may be measured in a fluid interchange portion, such as a tap, water inlet from a distribution network, cooling water outlet, etc.

The method may further comprise performing thermal treatment including information of usage of the system. This may be provided directly by a program, for example a programmed scheduled activation of the system (e.g. scheduled activation of a heating system or an HVAC system), or by predictive models. For example, energy use and water use of domestic hot water systems can be further optimized by timing the heat shock as close as possible to water use events (such as taking a bath). Predictive models for domestic hot water use can be used. For example auto-regressive models with exogenous inputs (ARX-models) can be successfully applied for real-time forecasting purposes of daily or weekly hot water use patterns. These may include previous time steps of the output as an input into the models. This approach can also improve modelling with higher frequency data, such as sub-daily usage.

FIG 18 shows an example of control via a virtual twin simulation model 1801 of the real system. From the simulation of the model of the pump and boiler (which may also be model of a tank, or a reservoir, further including a heater) for a particular design of a fluid distribution system, the virtual twin system predicts the presence of bacteria (e.g. *Legionella pneumophila*). This sets a boundary. Based thereon, the energy spent on heating the fluid can be optimized. For example, as long as the amount of bacteria does not reach the threshold, the temperature can be reduced to a comfort temperature. Then the results of the distributed temperature and the predicted energy can be included in the models of the pump and boiler. Temperatures and flow rate in the system can be monitored in real time. The data can be used in a dynamic simulation of the model, taking into account dynamics of the system (for example, thermohydraulic dynamics, such as flux, and biologic dynamics, such as presence of nutrients) in order to predict the amount of bacteria (L. pneumophila) at the fluid interchange portions (e.g. taps). The data and results of simulation can be used by the control unit to set a thermal treatment to control bacterial activity.

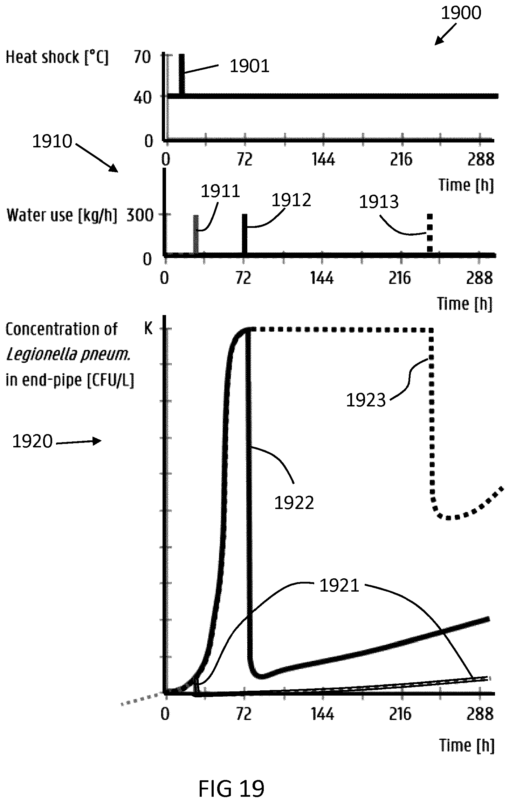

FIG 19 shows three graphs with the predicted *L. pneumophila* concentration in an end-pipe (for example an end pipe to a shower) in relation to tap moments and heat shock. The top graph 1900 shows the moment of heat shock as a peak 1901, where the water is set to 70°C for a short period. It is noted that, for the remaining of the time, the water is not kept at 60°C, but at 40°C, so less use of energy is needed for heating. The middle graph 1910 shows three different tap cycles: a first cycle 1911 where a tap is used closely after the shock, a second cycle 1912 where a tap is used after 2 days from the shock (different tap from the first cycle), and a third cycle 1913 where the tap not used up to six days after the heat shock (a different tap from the first two). The bottom graph 1920 shows a first line 1921 with the concentration of bacteria in the end-pipe for the first cycle 1911, a second line 1922 for the concentration for the second cycle 1912, and a third line 1923 for the bacterial concentration in the end-pipe for the third cycle 1913 six days after the heat shock. Note that the time axis is the same for the three graphs and can be compared from one graph to the other. Right after the shock, bacterial concentration is reduced below a predetermined level and starts growing. In the given example, while the first concentration 1921 close to the heat shock is very low, then drops again due to removal of bacteria through the tap, and then grows slowly, in the second cycle 1922 the concentration reaches dangerous values two days after the shock. The water usage reduces the amount of bacteria, and then it grows at a faster rate than in the first case, since due to exponential growth behavior, the growth is dependent on the starting concentration. In case the tap is not used for six days, the concentration saturates to K levels (the carrying capacity), and water usage does not reduce the amount of bacteria as much as if the tap was used after two days, also growing faster than in the two other cases, after the tap was cycled. Thus, it can be seen that concentration of bacteria (in this particular example, *Legionella pneumophila*) in an end-pipe is strongly related to the tap moment.

It is noted that it is not necessary to flush each tap if the tap is used shortly after the heat shock. In this way water and energy can be saved, e.g. by timing a heat shock according to predictive models and adaptive patterns of water usage. Additionally, scalding prevention can be taken into account.

In one aspect, the present invention also relates to a computer program product that, when implemented on a processor, performs the different steps of the methods as described above. In other words, the present invention also relates to for example software programs performing the method steps as described above for the above methods.

In yet another aspect, the present invention also relates to a method for adapting an existing distribution system. Such a method may for example include installing a controller as described in the first aspect in the existing distribution system and adjusting the controller to parameters of the existing distribution system. Such an adjusting typically may be performed in a calibration step and results in the fact that the modelling takes into account the parameters of the existing distribution system, so that accurate modelling of the situation of the existing distribution system is obtained. The present invention thus can be implemented in an existing fluid distribution system according to the following example. A fluid distribution system may for example be adapted, a control unit (e.g. controller) according to embodiments of the first aspect may be installed in the fluid distribution system including heating means or a heater, and/or a heater may also be installed for being used in combination with the control unit. It may be installed in a DHW system, thus including the control unit and adapting the heater (e.g. the heater in the boiler of the DHW system) so it performs heating according to output signals of the control unit. It may also be installed in a cooling/heating unit, heat exchangers, and/or HVAC systems. Further heaters can be included in parts in contact with fluid susceptible of contamination (e.g. water from condensation, drip trays, etc.).

Because the control unit is programmable, its module may be loaded with the necessary models of bacterial growth in the fluid distribution system, for that particular fluid distribution system where the control unit needs to be installed. Also, other or different models can be used for different bacterias or genus thereof. It is to be noted that the models shown in the examples are for Legionella, whereas similar models are applicable for other bacteria. Whereas the general behavior typically is similar, the actual concentrations (y-values) may be different for different bacteria types.

In particular, the present invention thus also includes a method for calibrating the module of the control unit based on parameters of the fluid distribution system, including thermohydraulic and biologic models of bacterial growth. This can be done as part of the programming or reprogramming of the control unit. For example, these parameters may include the parameters as given in the table below. Parameters are the start concentration of the Legionella, the volume of the biofilm, the roughness, the number of segments, the mass transfer coefficient, the nutrients, the growth equation of Legionella in biofilm and the growth equation of Legionella in the fluid.

| Component | Parameter |
|---|---|
| Boiler | Start concentration Legionella $C_{start}$ [CFU/l] |
|  | Volume of biofilm [m$^3$] |
|  | Roughness [m] |
|  | Number of segments [-] |
| Pipes | Start concentration Legionella $C_{start}$ [CFU/l] |
|  | Volume of biofilm [m$^3$] |
|  | Roughness [mm] |
|  | Number of segments [-] |
| Component independent | Mass transfer coefficient [m/s] |
|  | Growth equation of Legionella in water [CFU/l] |
|  | Growth equation of Legionella in biofilm [CFU/l] |
|  | Nutrients [CFU/l => kg/m$^3$] |

This tailored approach, adapting the models for simulation and running dynamic simulations and adapting thermal treatments when required, results in an effective bacterial control in fluid systems with lower consumption of energy, avoiding waste energy and water.

## Claims

1. A controller (100, 120, 130) adapted to regulate at least one de-bacterisation unit (201) of a fluid system (200, 210, 230), the fluid system (200, 210, 230) comprising the de-bacterisation unit, a production unit for producing a heated fluid heated to a predetermined temperature, at least one pipe for transporting the fluid from the production unit to at least one fluid outlet, the at least one fluid outlet and at least one first sensing unit for sensing a first temperature of the fluid at a first location in the fluid system as a function of time, the control unit (100, 120, 130)

   - including a module (101, 124), the module including an input for receiving the first temperature of the fluid as a function of time, wherein
   - the module is being adapted for obtaining second temperatures at a plurality of locations throughout the fluid system as a function of time, and wherein, for obtaining the second temperatures,

      ∘ the module is being programmed for thermohydraulic modelling the fluid system and for determining based thereon and taking into account said first temperature, the second temperatures as a function of time at a plurality of locations throughout the fluid system, and/or
      ∘ wherein the module comprises an input for receiving the second temperatures as a function of time from a plurality of second sensing units located at a plurality of second locations throughout the fluid system.

- the module is being programmed for modelling bacterial growth in the fluid throughout the fluid system as a function of time based on the obtained second temperatures and for predicting, based on the modelling, a bacterial concentration at the at least one fluid outlet over time, and
- being adapted for driving the de-bacterisation unit based on the predicted bacterial concentration, wherein the control unit is adapted for determining, based on said predicted bacterial concentration over time obtained by the module (101, 124), moments in time when the bacterial concentration reaches a predetermined value in the fluid system and for, in reply thereto, driving at these moments in time the de-bacterisation unit (201) so as to reduce bacterial concentration in the fluid system (200, 210, 230), **characterized in that** the module is further being programmed for modelling bacterial growth in a biofilm throughout the fluid system, and for modelling interaction between bacterial growth in the fluid and bacterial growth in the biofilm.

2. A controller according to claim 1, wherein the module is being adapted for obtaining the second temperatures at locations of at least two different fluid system parts throughout the fluid system.

3. A controller according to any of claims 1-2, the module including a further input for receiving a first flow rate of the fluid as a function of time, the first flow rate being sensed by the at least one sensing unit of the fluid system, and said module being adapted for obtaining second flow rates at a plurality of locations throughout the fluid system as function of time, and wherein, for obtaining the second flow rates,

  ◦ the module is being programmed for thermohydraulic modelling the fluid system and for determining based thereon and taking into account said first flow rate, the second flow rates as a function of time at a plurality of locations throughout the fluid system, and/or
  ◦ wherein said module is adapted for receiving the second flow rates as a function of time from a plurality of further sensing units located at a plurality of second locations throughout the fluid system.

4. A controller according to any of claims 1-3, wherein the de-bacterisation unit comprises any of a heater for heating the fluid for reducing the bacterial concentration, a chemical unit for inducing a chemical process for reducing the bacterial concentration, an electrochemical unit for reducing the bacterial concentration or a unit for reducing the bacterial concentration based on UV illumination or filtration.

5. A controller according to any of claims 1-4, wherein the de-bacterisation unit comprises a heater of the production unit for producing a heated fluid, the heater thus, on the one hand, being arranged for, when required, heating the fluid to a comfort temperature at the at least one fluid output and on the other hand being arranged for inducing a heat shock for reducing the bacterial concentration throughout the fluid system when the predicted bacterial concentration reaches the predetermined value at the at least one fluid outlet.

6. A controller of any of claims 1-5 wherein the module is programmed for modelling bacterial growth of legionella throughout the fluid system and wherein modelling legionella growth include information regarding the variation of concentration over time as function of temperature at a temperature at least between 20°C and 45°C for legionella growth in fluid and optionally also in biofilm.

7. A controller of any one of the previous claims wherein the module (101, 124) further comprises predictive algorithms for predicting fluid consumption, based on fluid consumption behavior of the user, thereby allowing the control unit to anticipate fluid consumption and adjust regulation of the de-bacterisation unit.

8. A controller of any one of the previous claims wherein modelling bacterial growth in the fluid and bacterial growth in the biofilm comprises modelling bacterial growth in the fluid and in the biofilm of any of an air conditioning system, ventilation system, cooling system, or heating system, or a hot water distribution system.

9. A fluid circulation or distribution system (200, 210) including a controller according to any of claims 1 to 8, a heater, and any of a heat exchanger, and/or a fluid circulation system, and/or a condenser, and/or a cooling tower (203) and/or a hot water storage tank (202, 212, 232), at least one pipe and at least one fluid outlet.

10. A method of regulating at least one de-bacterisation unit of a fluid system for controlling a bacterial concentration from a fluid below a predetermined value, the fluid system (200, 210, 230) comprising the de-bacterisation unit, a production unit for producing the fluid heated to a comfort temperature, at least one pipe for transporting the fluid from the fluid production unit to at least one fluid outlet, the at least one fluid outlet and the control unit (100, 120, 130), the method including the steps of

- sensing a first temperature of the fluid at a first location in the fluid system as a function of time
- obtaining second temperatures at a plurality of locations throughout the fluid system as function of time, said obtaining the second temperatures comprising

thermohydraulic modelling the fluid system for determining based thereon and taking into account the first temperature, the second temperatures as a function of time at a plurality of locations throughout the fluid system, and/or
sensing the second temperatures of the fluid at the plurality of different locations throughout the fluid system as a function of time.

- modelling bacterial growth in the fluid and in a biofilm throughout the fluid system as function of time based on the obtained second temperatures in the system, and modelling interaction between bacterial growth in the fluid and bacterial growth in the biofilm
- predicting, based on the modelling, the bacterial concentration at the at least one fluid outlet over time,
- driving the de-bacterisation unit,

wherein the method comprises determining, based on said predicted bacterial concentration over time obtained by the module (101, 124), moments in time when the bacterial concentration reaches the predetermined value in the fluid system and for, in reply thereto, driving at these moments in time the de-bacterisation unit (201) so as to reduce bacterial concentration in the fluid system (200, 210, 230).

11. A method according to claim 10, the method further comprising the steps of sensing a first flow rate of the fluid in the fluid system as a function of time and obtaining second flow rates of the fluid at the plurality of locations throughout the fluid system as function of time.

12. A method according to any of claims 10-11, wherein modeling bacterial growth comprises predictive simulating taking into account fluid consumption behavior of the user, thereby allowing the control unit to anticipate fluid consumption and adjust regulation of the de-bacterisation unit.

13. A method of adapting a fluid system comprising a heater, the method including the step of installing the controller of any of claims 1 to 8 in a fluid system.

14. The method of the previous claim further including calibrating the module of the control unit based on parameters of the fluid distribution system, and/or for automatically calibrating the module of the control unit and/or for calibrating the module based on a self-learning algorithm.

**Patentansprüche**

1. Steuerung (100, 120, 130), die ausgelegt ist, um mindestens eine Entbakterisierungseinheit (201) eines Fluidsystems (200, 210, 230) zu regulieren, wobei das Fluidsystem (200, 210, 230) die Entbakterisierungseinheit, eine Produktionseinheit zur Herstellung eines erwärmten Fluids, das auf eine vorbestimmte Temperatur erwärmt wird, mindestens ein Rohr zum Transportieren des Fluids von der Produktionseinheit zu mindestens einem Fluidauslass, den mindestens einen Fluidauslass und mindestens eine erste Sensoreinheit zum Erfassen einer ersten Temperatur des Fluids an einem ersten Ort im Fluidsystem in Abhängigkeit von der Zeit umfasst, wobei die Steuereinheit (100, 120, 130)

- ein Modul (101, 124) einschließt, wobei das Modul eine Eingabe zum Empfangen der erste Temperatur des Fluids in Abhängigkeit von der Zeit einschließt, wobei
- das Modul zum Erhalten zweiter Temperaturen an einer Vielzahl von Stellen im gesamten Fluidsystem in Abhängigkeit von der Zeit ausgelegt ist, und wobei zum Erhalten der zweiten Temperaturen,

- das Modul für die thermohydraulische Modellierung des Fluidsystems und zum Bestimmen, basierend darauf und unter Berücksichtigung der ersten Temperatur, der zweiten Temperaturen in Abhängigkeit von der Zeit an der Vielzahl von Stellen im gesamten Fluidsystem programmiert ist, und/oder
- wobei das Modul einen Eingang zum Empfangen der zweiten Temperaturen in Abhängigkeit von der Zeit von einer Vielzahl von zweiten Sensoreinheiten umfasst, die sich an einer Vielzahl von zweiten Stellen im gesamten Fluidsystem befindet,

- das Modul programmiert ist, um das Bakterienwachstum in dem Fluid im gesamten Fluidsystem in Abhängigkeit von der Zeit basierend auf den erhaltenen zweiten Temperaturen zu modellieren und um basierend auf der Modellierung eine Bakterienkonzentration an dem mindestens einen Flüssigkeitsauslass über die Zeit vorherzusagen, und
- zum Antreiben der Entbakterisierungseinheit basierend auf der vorhergesagten Bakterienkonzentration ausgelegt ist,

wobei die Steuereinheit ausgelegt ist, um, basierend auf der vom Modul (101, 124) über die Zeit vorhergesagten Bakterienkonzentration, die Zeitpunkte zu bestimmen, zu denen die Bakterienkonzentration im Fluidsystem einen vorbestimmten Wert erreicht, und als Reaktion, zu diesen Zeitpunkten die Entbakterisierungseinheit (201) anzutreiben, um die Bakterienkonzentration im -Fluidsystem (200, 210, 230) zu reduzieren,
**dadurch gekennzeichnet, dass** das Modul weiter für die Modellierung des Bakterienwachstums in einem Biofilm im gesamten Fluidsystem und für die Modellierung der Wechselwirkung zwischen Bakterienwachstum in dem Fluid und Bakterienwachstum im Biofilm programmiert ist.

2.  Steuerung nach Anspruch 1, wobei das Modul dazu ausgelegt ist, die zweiten Temperaturen an Stellen von mindestens zwei unterschiedlichen Fluidsystemteilen im gesamten Fluidsystem zu erhalten.

3.  Steuerung nach einem der Ansprüche 1 bis 2, wobei das Modul einen weiteren Eingang zum Empfangen einer ersten Durchflussrate des Fluids in Abhängigkeit von der Zeit einschließt, wobei die erste Durchflussrate von der mindestens einen Sensoreinheit des Fluidsystem erfasst wird, und wobei das Modul dazu ausgelegt ist, um zweite Durchflussraten an einre Vielzahl von Stellen im gesamten Fluidsystem in Abhängigkeit von der Zeit zu erhalten, und wobei zum Erhalten der zweiten Durchflussraten

    - das Modul für die thermohydraulische Modellierung des Fluidsystems und zum Bestimmen, basierend darauf und unter Berücksichtigung der ersten Durchflussrate, der zweiten Durchflussraten in Abhängigkeit von der Zeit an der Vielzahl von Stellen im gesamten Fluidsystem programmiert ist, und/oder
    - wobei das Modul dazu ausgelegt ist, um die zweiten Durchflussraten in Abhängigkeit von der Zeit von einer Vielzahl von weiteren Sensoreinheiten zu erhalten, die sich an einer Vielzahl von zweiten Stellen im gesamten Fluidsystem befindet.

4.  Steuerung nach einem der Ansprüche 1 bis 3, wobei die Entbakterisierungseinheit ein beliebiges von einer Heizung zum Erwärmen des Fluids zur Reduzierung der Bakterienkonzentration, einer Chemikalieneinheit zum Auslösen eines chemischen Prozesses zur Reduzierung der Bakterienkonzentration, einer elektrochemischen Einheit zur Reduzierung der Bakterienkonzentration oder einer Einheit zur Reduzierung der Bakterienkonzentration basierend auf UV-Beleuchtung oder -Filtration umfasst.

5.  Steuerung nach einem der Ansprüche 1 bis 4, wobei die Entbakterisierungseinheit eine Heizung der Produktionseinheit zum Erzeugen eines erwärmten Fluids umfasst, wobei die Heizung also einerseits ausgelegt ist zum Erwärmen, wenn erforderlich, des Fluids auf eine Komforttemperatur an dem mindestens einen Fluidausgang und andererseits dazu ausgelegt ist, um einen Hitzeschock auszulösen, um die Bakterienkonzentration im gesamten Fluidsystem zu reduzieren, wenn die vorhergesagte Bakterienkonzentration an dem mindestens einen Fluidausgang den vorbestimmten Wert erreicht.

6.  Steuerung nach einem der Ansprüche 1 bis 5, wobei das Modul für die Modellierung des Bakterienwachstums von Legionella im gesamten Fluidsystem programmiert ist und wobei die Modellierung des Legionella-Wachstums Informationen über die Konzentrationsschwankung über die Zeit in Abhängigkeit von der Temperatur bei einer Temperatur zwischen mindestens 20°C und 45°C für Legionella-Wachstum in Fluid und optional auch in Biofilm einschließt.

7.  Steuerung nach einem der vorstehenden Ansprüche, wobei das Modul (101, 124) weiter Vorhersagealgorithmen zur Vorhersage des Fluidverbrauchs basierend auf dem Fluidverbrauchsverfhalten des Benutzers umfasst, wodurch die Steuereinheit den Fluidverbrauch antizipieren und die Regelung der Entbakterisierungseinheit einstellen kann.

8. Steuerung nach einem der vorstehenden Ansprüche, wobei die Modellierung des Bakterienwachstums in dem Fluid und des Bakterienwachstums im Biofilm die Modellierung des Bakterienwachstums in dem Fluid und Biofilm eines von einem Klimaanlagensystem, Lüftungssystem, Kühlsystem, Heizsystem oder Warmwasserverteilungssystem umfasst.

9. Fluidzirkulations- oder-verteilungssystem (200, 210), einschließlich einer Steuerung nach einem der Ansprüche 1 bis 8, einer Heizung und eines Wärmetauschers und/oder eines Fluidzirkulationssystems und/oder eines Kondensators und/oder eines Kühlturms (203) und/oder eines Warmwasserspeichertanks (202, 212, 232), mindestens eines Rohrs und mindestens eines Flüssigkeitsauslasses.

10. Verfahren zur Regulierung mindestens einer Entbakterisierungseinheit eines Fluidsystems zum Steuern einer Bakterienkonzentration von einem Fluid unter einem vorbestimmten Wert, wobei das Fluidsystem (200, 210, 230) die Entbakterisierungseinheit, eine Produktionseinheit zum Erzeugen des auf eine Komforttemperatur erwärmten Fluids, mindestens ein Rohr zum Transportieren des Fluids aus der Fluidproduktionseinheit zu mindestens einem Fluidauslass, den mindestens einen Fluidauslass und die Steuereinheit (100, 120, 130) umfasst, wobei das Verfahren die folgenden Schritte einschließt

   - Erfassen einer ersten Temperatur des Fluids an einer ersten Stelle in dem Fluidsystem in Abhängigkeit von der Zeit
   - Erhalten von zweiten Temperaturen an einer Vielzahl von Stellen im gesamten Fluidsystem in Abhängigkeit von der Zeit, wobei das Erhalten der zweiten Temperaturen umfasst

      thermohydraulische Modellierung des Fluidsystems zum Bestimmen, basierend darauf und unter Berücksichtigung der ersten Temperatur, der zweiten Temperaturen in Abhängigkeit von der Zeit an der Vielzahl von Stellen im gesamten Fluidsystem und/oder
      Erfassen der zweiten Temperaturen des Fluids an der Vielzahl von unterschiedlichen Stellen im gesamten Fluidsystem in Abhängigkeit von der Zeit.

      - Modellieren des Bakterienwachstums in dem Fluid und in einem Biofilm im gesamten Fluidsystem in Abhängigkeit von der Zeit basierend auf den erhaltenen zweiten Temperaturen im System und Modellieren der Wechselwirkung zwischen Bakterienwachstum im Fluid und Bakterienwachstum im Biofilm,
      - Vorhersagen der Bakterienkonzentration an dem mindestens einen Fluidausgang über die Zeit basierend auf der Modellierung,
      - Antreiben der Entbakterisierungseinheit,

   wobei das Verfahren das Bestimmen, basierend auf der vorhergesagten Bakterienkonzentration über die Zeit, die durch das Modul (101, 124) erhalten wird, der Zeitpunkte, zu denen die Bakterienkonzentration im Fluidsystem den vorbestimmten Wert erreicht, und als Reaktion darauf, zu diesen Zeitpunkten die Entbakterisierungseinheit (201) anzutreiben, um die Bakterienkonzentration im -Fluidsystem (200, 210, 230) zu reduzieren.

11. Verfahren nach Anspruch 10, wobei das Verfahren weiter die Schritte des Erfassens einer ersten Durchflussrate des Fluids im Fluidsystem in Abhängigkeit von der Zeit und des Erhaltens zweiter Durchflussraten des Fluids an der Vielzahl von Stellen im gesamten Fluidsystem in Abhängigkeit von der Zeit umfasst.

12. Verfahren nach einem der Ansprüche 10 bis 11, wobei die Modellierung des Bakterienwachstums eine prädiktive Simulation unter Berücksichtigung des Fluidverbrauchverhaltens des Benutzers umfasst, wodurch die Steuereinheit den Fluidverbrauch antizipieren und die Regelung der Entbakterisierungseinheit einstellen kann.

13. Verfahren zur Anpassung eines Fluidsystems, das eine Heizung umfasst, wobei das Verfahren den Schritt des Installierens der Steuerung nach einem der Ansprüche 1 bis 8 in einem Fluidsystem einschließt.

14. Verfahren nach dem vorstehenden Anspruch, weiter einschließend das Kalibrieren des Moduls der Steuereinheit basierend auf Parametern des Fluidverteilungssystems und/oder das automatische Kalibrieren des Moduls der Steuereinheit und/oder das Kalibrieren des Moduls basierend auf einem selbstlernenden Algorithmus.

**Revendications**

1. Un contrôleur (100, 120, 130) adapté pour réguler au moins une unité de débactérisation (201) d'un système de fluide (200, 210, 230), le système de fluide (200, 210, 230) comprenant l'unité de débactérisation, une unité de production pour produire un fluide chauffé à une température prédéterminée, au moins un tuyau pour transporter le fluide de l'unité de production à au moins une sortie de fluide, ladite au moins une sortie de fluide et au moins une première unité de détection pour détecter une première température du fluide à un premier emplacement dans le système de fluide en fonction du temps, l'unité de commande (100, 120, 130)

   • comprenant un module (101, 124), le module comprenant une entrée pour recevoir la première température du fluide en fonction du temps,
   dans lequel
   • le module est adapté pour obtenir des deuxièmes températures à une pluralité d'emplacements dans tout le système de fluide en fonction du temps, et, pour obtenir les deuxièmes températures,

     ◦ le module est programmé pour modéliser thermohydrauliquement le système de fluide et pour déterminer, en fonction de cela et en tenant compte de ladite première température, les deuxièmes températures en fonction du temps à une pluralité d'emplacements dans tout le système de fluide, et/ou
     ◦ dans lequel le module comprend une entrée pour recevoir les deuxièmes températures en fonction du temps à partir d'une pluralité de deuxièmes unités de détection situées à une pluralité de seconds emplacements dans tout le système de fluide.

   • le module est programmé pour modéliser la croissance bactérienne dans le fluide à travers le système de fluide en fonction du temps en se basant sur les deuxièmes températures obtenues et pour prédire, sur la base de la modélisation, une concentration bactérienne au niveau de ladite au moins une sortie de fluide au fil du temps, et
   • est adapté pour commander l'unité de débactérisation en fonction de la concentration bactérienne prédite,

     dans lequel l'unité de commande est adaptée pour déterminer, sur la base de ladite concentration bactérienne prédite au fil du temps obtenue par le module (101, 124), les moments dans le temps où la concentration bactérienne atteint une valeur prédéterminée dans le système de fluide et, en réponse à cela, commander à ces moments dans le temps l'unité de débactérisation (201) afin de réduire la concentration bactérienne dans le système de fluide (200, 210, 230),
     **caractérisé en ce que** le module est en outre programmé pour modéliser la croissance bactérienne dans un biofilm à travers le système de fluide, et pour modéliser l'interaction entre la croissance bactérienne dans le fluide et la croissance bactérienne dans le biofilm.

2. Un contrôleur selon la revendication 1, dans lequel le module est adapté pour obtenir les deuxièmes températures à des emplacements d'au moins deux parties différentes du système de fluide dans tout le système de fluide.

3. Un contrôleur selon l'une quelconque des revendications 1-2, le module comprenant une autre entrée pour recevoir un débit de fluide en fonction du temps, le premier débit étant détecté par ladite au moins une unité de détection du système de fluide, et ledit module étant adapté pour obtenir des deuxièmes débits à une pluralité d'emplacements dans tout le système de fluide en fonction du temps, et, pour obtenir les deuxièmes débits,

     ◦ le module est programmé pour modéliser thermohydrauliquement le système de fluide et pour déterminer, en fonction de cela et en tenant compte dudit premier débit, les deuxièmes débits en fonction du temps à une pluralité d'emplacements dans tout le système de fluide, et/ou
     ◦ ledit module est adapté pour recevoir les deuxièmes débits en fonction du temps à partir d'une pluralité d'autres unités de détection situées à une pluralité de seconds emplacements dans tout le système de fluide.

4. Un contrôleur selon l'une quelconque des revendications 1-3, dans lequel l'unité de débactérisation comprend soit un dispositif de chauffage pour chauffer le fluide afin de réduire la concentration bactérienne, soit une unité chimique pour induire un processus chimique pour réduire la concentration bactérienne, soit une unité électrochimique pour réduire la concentration bactérienne, soit une unité pour réduire la concentration bactérienne basée sur une illumination UV ou une filtration.

5. Un contrôleur selon l'une quelconque des revendications 1-4, dans lequel l'unité de débactérisation comprend un dispositif de chauffage de l'unité de production pour produire un fluide chauffé, ledit dispositif de chauffage étant ainsi, d'une part, conçu pour, lorsque nécessaire, chauffer le fluide à une température de confort au niveau de ladite au moins une sortie de fluide et, d'autre part, conçu pour provoquer un choc thermique pour réduire la concentration bactérienne dans tout le système de fluide lorsque la concentration bactérienne prédite atteint la valeur prédéterminée au niveau de ladite au moins une sortie de fluide.

6. Un contrôleur selon l'une quelconque des revendications 1-5, dans lequel le module est programmé pour modéliser la croissance bactérienne de la légionelle dans tout le système de fluide et dans lequel la modélisation de la croissance de la légionelle inclut des informations concernant la variation de concentration en fonction du temps en fonction de la température à une température d'au moins 20°C et 45°C pour la croissance de la légionelle dans le fluide et éventuellement aussi dans le biofilm.

7. Un contrôleur selon l'une quelconque des revendications précédentes, dans lequel le module (101, 124) comprend en outre des algorithmes prédictifs pour prédire la consommation de fluide, en fonction du comportement de consommation de fluide de l'utilisateur, permettant ainsi à l'unité de commande d'anticiper la consommation de fluide et d'ajuster la régulation de l'unité de débactérisation.

8. Un contrôleur selon l'une quelconque des revendications précédentes, dans lequel la modélisation de la croissance bactérienne dans le fluide et la croissance bactérienne dans le biofilm comprend la modélisation de la croissance bactérienne dans le fluide et dans le biofilm d'un système de climatisation, d'un système de ventilation, d'un système de refroidissement, ou d'un système de chauffage, ou d'un système de distribution d'eau chaude.

9. Un système de circulation ou de distribution de fluide (200, 210) comprenant un contrôleur selon l'une quelconque des revendications 1 à 8, un dispositif de chauffage, et tout élément parmi un échangeur de chaleur et/ou un système de circulation de fluide et/ou un condenseur et/ou une tour de refroidissement (203) et/ou un réservoir de stockage d'eau chaude (202, 212, 232), au moins un tuyau et au moins une sortie de fluide.

10. Un procédé de régulation d'au moins une unité de débactérisation d'un système de fluide pour contrôler une concentration bactérienne dans un fluide en dessous d'une valeur prédéterminée, le système de fluide (200, 210, 230) comprenant l'unité de débactérisation, une unité de production pour produire le fluide chauffé à une température de confort, au moins un tuyau pour transporter le fluide de l'unité de production à au moins une sortie de fluide, ladite au moins une sortie de fluide et l'unité de commande (100, 120, 130), le procédé comprenant les étapes suivantes :

   • détection d'une première température du fluide à un premier emplacement dans le système de fluide en fonction du temps,
   • obtention de deuxièmes températures à une pluralité d'emplacements dans tout le système de fluide en fonction du temps, ladite obtention des deuxièmes températures comprenant : la modélisation thermohydraulique du système de fluide pour déterminer, en fonction de cela et en tenant compte de la première température, les deuxièmes températures en fonction du temps à une pluralité d'emplacements dans tout le système de fluide, et/ou la détection des deuxièmes températures du fluide à la pluralité de différents emplacements dans tout le système de fluide en fonction du temps,
   • modélisation de la croissance bactérienne dans le fluide et dans un biofilm à travers le système de fluide en fonction du temps en se basant sur les deuxièmes températures obtenues dans le système, et modélisation de l'interaction entre la croissance bactérienne dans le fluide et la croissance bactérienne dans le biofilm,
   • prédiction, sur la base de la modélisation, de la concentration bactérienne au niveau de ladite au moins une sortie de fluide au fil du temps,
   • commande de l'unité de débactérisation,

dans lequel le procédé comprend la détermination, sur la base de ladite concentration bactérienne prédite au fil du temps obtenue par le module (101, 124), des moments dans le temps où la concentration bactérienne atteint la valeur prédéterminée dans le système de fluide et, en réponse à cela, la commande à ces moments dans le temps de l'unité de débactérisation (201) afin de réduire la concentration bactérienne dans le système de fluide (200, 210, 230).

11. Un procédé selon la revendication 10, le procédé comprenant en outre les étapes de détection d'un premier débit du fluide dans le système de fluide en fonction du temps et d'obtention de deuxièmes débits du fluide à la pluralité d'emplacements dans tout le système de fluide en fonction du temps.

**12.** Un procédé selon l'une quelconque des revendications 10-11, dans lequel la modélisation de la croissance bactérienne comprend une simulation prédictive en tenant compte du comportement de consommation de fluide de l'utilisateur, permettant ainsi à l'unité de commande d'anticiper la consommation de fluide et d'ajuster la régulation de l'unité de débactérisation.

**13.** Un procédé d'adaptation d'un système de fluide comprenant un dispositif de chauffage, le procédé comprenant l'étape d'installation du contrôleur selon l'une quelconque des revendications 1 à 8 dans un système de fluide.

**14.** Le procédé de la revendication précédente comprenant en outre l'étalonnage du module de l'unité de commande sur la base de paramètres du système de distribution de fluide, et/ou l'étalonnage automatique du module de l'unité de commande et/ou l'étalonnage du module sur la base d'un algorithme d'apprentissage automatique.

FIG 1

FIG 2

FIG 3

FIG 4

FIG 5

FIG 6

FIG 7

801

<u>803</u>

802

800

FIG 8

900

port_a

902

903

port_b

901

FIG 9

FIG 10

FIG 11

FIG 12

FIG 13

FIG 14

FIG 15

FIG 16

FIG 17

EP 3 794 287 B1

FIG 18

FIG 19

**REFERENCES CITED IN THE DESCRIPTION**

**Patent documents cited in the description**

- WO 2013014411 A

**Non-patent literature cited in the description**

- Coupled thermodynamic and biologic modeling of Legionella Pneumophila proliferation in domestic hot water systems. **ELISA VAN KENHOVE et al.** Healthy Buildings Conference, Eindhoven. 2015